# EUROPÄISCHE PATENTANMELDUNG

(11) **EP 4 467 990 A1**
(43) Veröffentlichungstag der Anmeldung: **27.11.2024**
(21) Anmeldenummer: 24177447.0
(22) Anmeldetag: 22.05.2024
(51) Int. Cl.: G01R 1/04, G01R 15/18, H02B 1/04, H02B 1/052, H01F 27/06, H01F 38/28, H02B 1/20

(54) **WANDLERBAUSTEIN**

(30) Priorität: 23.05.2023 DE 202023102838 U
(71) Anmelder: ABN GmbH, 74196 Neuenstadt (DE)
(72) Erfinder: BENDER, Rainer, 74196 Neuenstadt (DE); HÖHN, Werner, 74196 Neuenstadt (DE); BRAUN, Andreas, 74196 Neuenstadt (DE)
(74) Vertreter: Gleim Petri Patent- und Rechtsanwaltspartnerschaft mbB

(57) **Zusammenfassung**

Die Erfindung betrifft einen Wandlerbaustein (10) zum Anschließen einer Wandlerlasche. Der Wandlerbaustein (10) besitzt ein Unterteil (20), das an einem Montageelement befestigt werden kann und zumindest ein Oberteil (24), das an dem Unterteil (20) befestigt ist. Zwischen dem zumindest einen Oberteil (24) und dem Unterteil (20) ist zumindest einer Gewindeplatte positioniert. Darüber hinaus ist zumindest eine Anschlusslasche (26) vorhanden, die an dem zumindest einen Oberteil (24) lagefixiert werden kann. An der Unterseite (30) des Unterteils (20) können zwei kanalartige Einkerbungen (34, 36) vorhanden sind, die über den Seitenwänden einer Hutschiene positioniert werden können. Dabei kann eine der beiden kanalartigen Einkerbungen (36) hakenförmig und die andere der beiden kanalartigen Einkerbungen (34) etwa rechteckig ausgebildet sein. Im Bereich der rechteckigen Einkerbung (34) kann ein Sicherungselement (130) an dem Unterteil (20) vorhanden sein, dessen unterhalb der Umbiegung der Seitenwand der Hutschiene positioniert werden kann. Das zumindest eine Oberteil (24) kann über ein Sicherungselement (28), insbesondere über einen U-förmigen Sicherungsbügel (28) an dem Unterteil (20) fixiert werden.

## Beschreibung

### TECHNISCHES GEBIET

Die Erfindung betrifft einen Wanderbaustein. Bei einem Wandler handelt es sich um eine Baugruppe, die eine Energieform in eine andere Energieform umwandelt. Bei dem erfindungsgemäßen Wandlerbaustein kann es sich insbesondere um einen Stromwandler handeln. Ein Stromwandler gibt als Ausgangssignal einen Sekundärstrom von Milliampere bis wenigen Ampere ab, der im Wesentlichen proportional zum Primärstrom ist. Der zu messende Strom kann bei entsprechend hohem Windungszahl-Verhältnis nahezu beliebig hoch sein. Dabei weicht der Sekundärstrom bei einem Stromwandler gegenüber dem Primärstrom um einen Phasenverschiebungswinkel ab, der bei passendem Anschluss annähernd null ist.

### STAND DER TECHNIK

Wandlereinheiten sind grundsätzlich in unterschiedlichen Ausführungsformen bekannt. Die Wandler werden in der Regel mittels mehrerer Bolzenpaare an einer Montageplatte montiert. Die Montageplatte selbst kann insbesondere an den Hutschienen eines beispielsweise Anschlussraums befestigt werden. An den Bolzenpaaren werden in der Regel auch die Z-Winkel zum Anschluss der elektrischen Kabel befestigt. Bei der Montage des Wandlers muss daher darauf geachtet werden, dass sich die Z-Winkel nicht verdrehen. Bei einem solchen Verdrehen könnte es ansonsten vorkommen, dass die geforderten elektrischen Luftabstände nicht mehr eingehalten werden. In der Folge kann es zur Bildung von Lichtbögen kommen. Derartige Lichtbögen können eine Gefahr für den Monteur darstellen, durch die Brandgefahr aber auch für das Produkt selbst, das Gebäude und dessen Bewohner.

Aus der DE 20 2021 002 026 U1 ist eine Wandlereinheit mit zumindest einem Wandler bekannt, der mittels eines Bolzenpaares an einer Montageplatte befestigt ist. An zumindest einem der Bolzen des Bolzenpaares ist ein Anschlusselement befestigt. Darüber hinaus ist zumindest ein U-Winkel vorhanden. Dieser U-Winkel besitzt eine Ausnehmung in seiner Basisplatte, die über einen der Bolzen des Bolzenpaares gesteckt werden kann. Die seitlichen Kragwände des U-Winkels verdecken die Seitenkanten des Anschlusselements zumindest bereichsweise, so dass ein Verdrehen der Anschlusselemente verhindert werden kann.

### DARSTELLUNG DER ERFINDUNG

Ausgehend von diesem vorbekannten Stand der Technik liegt der Erfindung die Aufgabe zugrunde, einen verbesserten Wandlerbaustein anzugeben, der möglichst einfach und sicher montiert werden kann.

Der erfindungsgemäße Wandlerbaustein ist durch die Merkmale des Hauptanspruchs 1 gegeben. Ein entsprechendes elektromechanisches Bauteil ist durch die Merkmale des nebengeordneten Anspruchs 19 gegeben. Sinnvolle Weiterbildungen der Erfindung sind Gegenstand von sich an diese Ansprüche anschließenden weiteren Ansprüchen.

Der erfindungsgemäße Wandlerbaustein zum Anschließen einer Wandlerlasche besitzt ein Unterteil, das an einem Montageelement befestigbar ist. An dem Unterteil ist zumindest ein Oberteil befestigt, wobei eine Gewindeplatte zwischen dem zumindest einen Oberteil und dem Unterteil positioniert ist. Darüber hinaus ist eine Anschlusslasche als Verbindung zu der Wandlerlasche vorhanden. Diese Anschlusslasche ist an dem zumindest einen Oberteil lagefixiert.

Die Verwendung eines Unterteils und eines daran befestigten Oberteils führt zu einer besonders kompakten Bauweise, durch die auf die bislang üblichen Bolzenpaare verzichtet werden kann. Die einzelnen Wandlerbausteine können auf diese Weise besonders nah nebeneinander positioniert werden, was insbesondere bei mehrpoligen Wandlereinheiten vorteilhaft ist. Dadurch wird weniger des begrenzten Platzes in einem beispielsweise Zähler- und Verteilerschrank durch die Wandlereinheiten benötigt. Der Einsatz der Wandlerbausteine kann darüber hinaus die Montage der Wandlereinheiten und das Anschließen der Wandlerlaschen vereinfachen.

Das Unterteil wird erfindungsgemäß an einem Montageelement befestigt. Bei einem solchen Montageelement kann es sich insbesondere um eine Hutschiene oder um eine Montageplatte handeln. Sofern es sich bei dem Montageelement um eine Montageplatte handelt, können an dem Unterteil vorzugsweise mehrere Ösen angeformt sein, über die das Unterteil an der Montageplatte befestigt werden kann. Dies kann insbesondere über Schrauben erfolgen. Sofern es sich bei dem Montageelement dagegen um eine Hutschiene handelt, können in der Unterseite des Unterteils zwei kanalartige Einkerbungen vorhanden sein, die über den Seitenwände der Hutschiene positioniert werden können. Die Montage des Unterteils auf einer Hutschiene ist insofern vorteilhaft, dass das Unterteil und damit der gesamte Wandlerbaustein entlang der Längsrichtung der Hutschiene verschoben werden kann. Die Positionierung des Wandlerbausteins ist somit besonders flexibel, so dass eine Anpassung an unterschiedliche bauliche Gegebenheiten unproblematisch möglich ist. Um eine Befestigung sowohl an einer Montageplatte als auch an einer Hutschiene zu ermöglichen, können vorzugsweise sowohl die Ösen als auch die kanalartigen Einkerbungen an dem Unterteil vorhanden sein.

Zumindest eine der beiden kanalartigen Einkerbungen kann vorzugsweise hakenförmig ausgebildet sein. In einer solchen hakenförmigen Einkerbung kann eine der beiden Seitenwände der Hutschiene mit der oberen Umbiegung der Seitenwand eingesetzt werden. Sofern beide Einkerbungen hakenförmig ausgebildet sind, muss das Unterteil auf die Hutschiene aufgeschoben werden.

Alternativ oder zusätzlich dazu kann zumindest eine der beiden kanalartigen Einkerbungen etwa rechteckig ausgebildet sein. Die Breite der zumindest einen rechteckigen Einkerbung sollte in diesem Fall etwas größer sein als die Breite der Seitenwand der Hutschiene inklusive der oberen Umbiegung der Seitenwand. Sofern beide Einkerbungen rechteckig ausgebildet sind, kann das Unterteil von oben auf die Hutschiene aufgesetzt werden.

Die inneren Wände der beiden kanalartigen Einkerbungen können vorzugsweise an der Innenseite der Seitenwände der Hutschiene angelegt werden. Dadurch kann der Bereich zwischen den kanalartigen Einkerbungen in die Hutschiene eintauchen und das Unterteil zusätzlich stabilisieren. Auf diese Weise können Rotationskräfte durch das Unterteil aufgenommen werden, so dass eine Verdrehung des Unterteils innerhalb der Hutschiene nicht möglich ist. Da der gesamte Wandlerbaustein auf diese Weise bereits verdrehsicher gelagert ist, kann auf einen zusätzlichen Verdrehschutz der Anschlusslaschen verzichtet werden.

In einer besonders bevorzugten Ausführungsform kann eine der beiden Einkerbungen hakenförmig und die andere rechteckig ausgebildet sein. Um das Unterteil auf der Hutschiene zu befestigen, kann das Unterteil zunächst mit der hakenförmigen Einkerbung an der gewünschten Stelle der Hutschiene über eine der beiden Seitenwände der Hutschiene gestülpt werden. Dies erfolgt in einer schrägen Position des Unterteils, so dass die Seitenwand inklusive der oberen Umbiegung in die hakenförmige Einkerbung eingeführt werden kann. Anschließend wird das Unterteil auf die Hutschiene geschwenkt und mit der rechteckigen Einkerbung über die zweite Seitenwand geklappt. Auf diese Weise ist eine Positionierung des Unterteils an beliebigen Positionen der Hutschiene möglich, ohne das Unterteil über die gesamte Hutschiene bis zu dieser gewünschten Position verschieben zu müssen. Gleichzeitig ist bereits eine erste Befestigung des Unterteils an der Hutschiene erfolgt, so dass das Unterteil nicht mehr senkrecht von der Hutschiene abgenommen werden kann.

Um das Unterteil bei der Verwendung von zumindest einer rechteckigen Einkerbung an der Hutschiene zu fixieren, kann in einer vorteilhaften Ausführungsform ein Sicherungselement an dem Unterteil vorhanden sein. Dieses Sicherungselement kann ein Kragelement aufweisen, das unterhalb der Umbiegung der Seitenwand der Hutschiene positioniert werden kann. Sobald sich das Kragelement in seiner ZU-Position unterhalb der Umbiegung der Seitenwand befindet, kann das Unterteil nicht mehr ohne weiteres von der Hutschiene entfernt werden. Vorzugsweise kann das Sicherungselement eine Welle aufweisen, die in eine Vertiefung des Unterteils eingelegt werden kann. Um diese Welle kann das Sicherungselement verschwenkt werden, so dass das Kragelement aus der ZU-Position in eine AUF-Position verschwenkt werden kann. In der AUF-Position kann das Kragelement die Umbiegung der Seitenwand der Hutschiene freigeben, so dass das Unterteil wieder von der Hutschiene entfernt oder entlang der Hutschiene verschoben werden kann. Die Welle des Sicherungselements kann durch das an dem Unterteil befestigte Oberteil fixiert werden. Auf diese Weise kann das Sicherungselement während der Montage des Wandlerbausteins und der Befestigung des Wandlerbausteins auf der Hutschiene nicht versehentlich aus der Vertiefung rutschen und verloren gehen. Durch das Eintauchen des mittleren Bereichs zwischen den beiden kanalartigen Einkerbungen in die Hutschiene wird darüber hinaus auch das Kragelement vor Beschädigungen geschützt. Bei einer Verdrehung des Unterteils innerhalb der Hutschiene werden die auftretenden Kräfte unmittelbar von dem Unterteil abgefangen und gehen nicht auf das Kragelement über.

Durch die Verwendung eines solchen Kragelements ist es darüber hinaus möglich, das Unterteil zunächst in die gewünschte Position auf der Hutschiene zu schieben. Sobald diese gewünschte Position erreicht ist, kann diese Position durch das Kragelement lagefixiert werden. Im Gegensatz zu einer Montage des Unterteils auf einer Montageplatte mit vorgefertigten Schraublöchern, sind bei dieser Befestigungsmethode auch Zwischenmaße problemlos möglich. Bei einer Montageplatte war dies lediglich durch die Herstellung von zusätzlichen Bohrungen möglich. Insgesamt wird dadurch eine größere Variabilität bei der Montage des Unterteils erreicht.

Um das Kragelement in seiner ZU-Position unterhalb der Umbiegung der Seitenwand der Hutschiene lagezufixieren, kann an dem Kragelement in einer ersten Ausführungsform vorzugsweise zumindest eine seitliche Rastnase vorhanden sein. In der ZU-Position kann diese seitliche Rastnase des Kragelements in eine Vertiefung des Unterteils einrasten.

In einer zweiten Ausführungsform des Kragelements kann an dem Sicherungselement eine Ausnehmung vorhanden sein, an der ein Rasthaken des Unterteils in der ZU-Position des Sicherungselements einrasten kann.

Vorzugsweise kann zumindest ein Sicherungselement vorhanden sein, durch das das zumindest eine Oberteil an dem Unterteil fixiert werden kann.

In einer bevorzugten Ausführungsform kann an dem zumindest einen Oberteil zumindest ein Hakenelement vorhanden sein. In dem Unterteil kann zumindest eine Vertiefung ausgebildet sein, die die das zumindest eine Hakenelement eintaucht, wenn das zumindest eine Oberteil auf dem Unterteil aufliegt. In dem Unterteil kann zumindest ein Kanal ausgebildet sein. In diesen zumindest einen Kanal kann ein Sicherungsstift als Sicherungselement eingeführt werden. Der Sicherungsstift liegt dabei zumindest bereichsweise an der Innenseite des zumindest einen Hakenelements an. Auf diese Weise kann verhindert werden, dass das zumindest eine Oberteil von dem Unterteil abgehoben werden kann.

Alternativ dazu kann das zumindest eine Hakenelement auch an dem Unterteil vorhanden sein. Die zumindest eine Vertiefung und der zumindest eine Kanal wären in diesem Fall an dem zumindest einen Oberteil ausgebildet.

In einer vorteilhaften Ausführungsform kann das zumindest eine Hakenelement zumindest bereichsweise eine seitlich offene Nut aufweisen. Der zumindest eine Sicherungsstift kann in diesem Fall in die seitlich offene Nut des zumindest einen Hakenelements eingreifen. Die seitlich offene Nut kann in diesem Fall auch als zusätzliches Führungselement für den Sicherungsstift innerhalb des Kanals dienen.

Gegebenenfalls kann statt des zumindest einen Hakenelements auch zumindest eine geschlossene Öse vorhanden sein. In diesem Fall würde der zumindest eine Sicherungsstift durch die Öffnung der Öse hindurchgeführt werden.

Der zumindest eine Sicherungsstift kann vorzugsweise zumindest einen Rasthebel aufweisen, der parallel zur Längsrichtung des Sicherungsstifts verläuft. Die Rastnase des Rasthebels kann in eine Einkerbung des Unterteils beziehungsweise des zumindest einen Oberteils einrasten, so dass der Sicherungsstift nicht mehr versehentlich aus dem Kanal entfernt werden kann. Grundsätzlich sind in diesem Zusammenhang zwei unterschiedliche Rastnasen möglich. In einer ersten Variante kann die Rastnase so geformt sein, dass diese in der Einkerbung einrasten kann, um den Sicherungsstift in seiner eingeschobenen Position zu fixieren. Gleichzeitig kann diese Rastnase wieder aus der Einkerbung entfernt werden, um das Oberteil wieder von dem Unterteil entfernen zu können. In einer zweiten Variante kann die Rastnase so geformt sein, dass diese beim erstmaligen Einschieben des Sicherungsstifts in eine längere Einkerbung einrasten kann. Innerhalb dieser Einkerbung kann die Rastnase hin und her verschoben werden, so dass der Sicherungsstift in unterschiedlichen Positionen vorhanden sein kann. Gleichzeitig kann diese Rastnase so geformt sein, dass die Rastnase nicht mehr aus der Einkerbung entfernt werden kann. Der Sicherungsstift kann somit nicht mehr vollständig aus dem Kanal entfernt werden. Dies kann insbesondere sicherstellen, dass der Sicherungsstift nicht verloren gehen kann.

In einer vorteilhaften Ausführungsform können zwei Sicherungsstifte als Sicherungselement vorhanden sein. Entsprechend können auch zwei parallel verlaufende Kanäle in dem Unterteil beziehungsweise dem zumindest einen Oberteil vorhanden sein. In diesem Fall sollten an dem zumindest einen Oberteil beziehungsweise dem Unterteil zumindest zwei Hakenelemente vorhanden sein, so dass in Bereich von beiden Kanälen jeweils zumindest ein Hakenelement positioniert werden kann. Vorzugsweise können insgesamt vier Hakenelemente vorhanden sein, so dass im Bereich von jedem Kanal jeweils zwei Hakenelemente positioniert sind.

Die beiden Sicherungsstifte können vorzugweise durch einen Querbalken zu einem U-förmigen Sicherungsbügel verbunden sein. Auf diese Weise ist eine gleichmäßige Befestigung des zumindest einen Oberteils an dem Unterteil möglich, ohne mehrere Sicherungselemente zu benötigen. Dies reduziert die Gefahr, Bauteile zu verlieren oder die Montage eines Bauteils zu vergessen. Um den Sicherungsbügel möglichst einfach wieder zumindest ein Stück weit aus dem Wandlerbaustein entfernen zu können, kann an dem Querbalken eine Einkerbung oder eine Ausnehmung vorhanden sein. In diese Einkerbung oder Ausnehmung kann mit einem geeigneten Werkzeug, insbesondere mit einem Schraubendreher, eingegriffen werden, um den Sicherungsbügel wieder aus den beiden Kanälen herauszuziehen. In diesem Fall kann einer der beiden Sicherungsstifte mit einem Rasthebel mit einer Rastnase nach der oben beschriebenen ersten Variante und der andere der beiden Sicherungsstifte mit einem Rasthebel mit einer Rastnase nach der oben beschriebenen zweiten Variante ausgestattet sein.

In einer vorteilhaften Ausführungsform kann in dem zumindest einen Oberteil eine Vertiefung ausgebildet sein, in die die zumindest eine Anschlusslasche eingelegt werden kann. Die Anschlusslasche kann somit verdrehsicher an dem Oberteil gelagert werden. Da die Z-Laschen durch die Anschlusslaschen ersetzt werden, können die Anschlusslaschen deutlich kürzer als die Z-Laschen ausfallen, so dass der Wandlerbaustein kompakter als die aus dem Stand der Technik bekannten Lösungen ausgebildet werden kann.

In der zumindest einen Anschlusslasche können vorzugsweise zwei Durchbrüche für Anschlussschrauben vorhanden sein. Eine der beiden Anschlussschrauben kann für die Befestigung der Anschlusslasche an der Wandlerlasche genutzt werden. Die zweite Anschlussschraube kann für die Zugangsverdrahtung genutzt werden. Auf diese Weise können die Wandlerlasche und die Zugangsverdrahtung getrennt befestigt werden. Die Wandlerlasche kann somit entfernt werden, ohne die Zugangsverdrahtung entfernen zu müssen. Dies war bei der Verwendung einer Z-förmigen Anschlusslasche bislang nicht gegeben, da diese Z-förmige Lasche nach dem Lösen von der Wandlerlasche nicht mehr sicher befestigt war.

Die Zugangsverdrahtung musste daher aus Sicherheitsgründen ebenfalls entfernt werden. Darüber hinaus können die beiden Anschlussschrauben auch zur Befestigung einer langen Wandlerlasche mit Doppellochung genutzt werden.

Durch die Verwendung von Anschlussschrauben in Verbindung mit dem Wandlerbaustein kann darüber hinaus auf die bisher üblichen Isolatoren verzichtet werden. Diese Isolatoren wurden bislang von hinten an der Montageplatte verschraubt. Sobald die Montagplatte in einem Zähler- und Verteilerschrank positioniert war, waren die diesbezüglich verwendeten Schrauben nicht mehr zugänglich. Eine Wartung oder Reparatur des Isolators war daher nur sehr aufwändig möglich. Darüber hinaus war auch eine Kontrolle der Schraubbefestigung und ein gegebenenfalls erforderliches Nachziehen der Schrauben nicht mehr möglich. Bei dem vorliegenden Wandlerbaustein werden die Anschlussschrauben und die Wandlerbausteine selbst dagegen ausschließlich von vorne montiert, was eine deutliche Montageerleichterung darstellt. Insbesondere ist dadurch auch eine regelmäßige Überprüfung der Anschlussschrauben ohne größeren Aufwand möglich.

Durch die Möglichkeit, zwei Anschlussschrauben an der Anschlusslasche anbringen zu können, können darüber hinaus weitere elektromechanische Bauteile unmittelbar oberhalb der Anschlusslasche befestigt und kontaktiert werden. In diesem Fall müssen gegebenenfalls längere Anschlussschrauben eingesetzt werden. Der begrenzte Raum in einem Zähler- und Verteilerschrank kann somit optimal ausgenutzt werden.

Die zumindest eine Anschlusslasche kann insbesondere als Kupferplatte ausgebildet sein. Bei der Anschlusslasche kann es sich darüber hinaus auch um eine Stromschiene handeln.

In einer besonders bevorzugten Ausführungsform können in dem zumindest einen Oberteil zwei Ausnehmungen vorhanden sein, die durch einen Steg voneinander getrennt sind. Die Gewindeplatte kann in diesem Fall zwei erhabene Bereiche aufweisen, die innerhalb der Ausnehmungen des Oberteils positioniert werden können. Die erhabenen Bereiche der Gewindeplatte können somit direkt an der Unterseite der Anschlusslasche anliegen, so dass eine optimale Kontaktierung erreicht werden kann. Die Gewindeplatte kann auf diese Weise in dem Oberteil lagefixiert positioniert werden, so dass eine zusätzliche Sicherung der Gewindeplatte bereits vor der Fertigstellung der Montage des Wandlerbausteins möglich ist.

Darüber hinaus kann der Steg zwischen den beiden Ausnehmungen des Oberteils zu einem Gegenlager bei der Befestigung der Anschlusslasche an der Gewindeplatte dienen. Die Anschlusslasche und die Gewindeplatte können auf diese Weise sicher miteinander verschraubt und somit kontaktiert werden.

Im Bereich der beiden Ausnehmungen kann vorzugsweise zumindest ein Rasthaken vorhanden sein, durch den die Gewindeplatte zusätzlich fixierbar ist. Die Gewindeplatte kann von unten in das Oberteil eingelegt werden, wobei die Rastnase des Rasthakens unterhalb der Gewindeplatte einrastet. Dadurch kann bereits während des Transports und damit auch vor der eigentlichen Montage des Wandlerbausteins eine Sicherung der Gewindeplatte erfolgen.

An der zumindest einen Gewindeplatte können mehrere Kragstege vorhanden sein, die unterhalb des zumindest einen Oberteils positioniert sind. Die Kragstege können als zusätzliche Gegenlager bei der Befestigung der Anschlusslasche an der Gewindeplatte dienen. Vorzugsweise können die Kragstege in diesem Fall im Bereich neben den erhabenen Bereichen der Gewindeplatte vorhanden sein.

Die Gewindeplatte kann bei dem erfindungsgemäßen Wandlerbaustein vollständig werkzeuglos montiert werden. Lediglich zur Kontaktierung der Gewindeplatte mit der Anschlusslasche mittels der Anschlussschrauben ist die Verwendung eines Schraubenschlüssels erforderlich. Im Gegensatz dazu mussten die Isolatoren bei der bisherigen Lösung mittels Schrauben an einer Montageplatte befestigt werden.

In der zumindest einen Gewindeplatte können vorzugsweise zwei Anschlussmöglichkeiten für Anschlussschrauben vorhanden sein. Bei diesen beiden Anschlussmöglichkeiten kann es sich insbesondere um Gewindemuttern handeln, die eine direkte Kontaktierung ermöglichen. Die Gewindemuttern können einteilig mit der Gewindeplatte ausgebildet sein. Alternativ dazu können die Gewindemuttern auch in entsprechende Durchbrüche der Gewindeplatte eingepresst sein.

Vorzugsweise kann an der zumindest einen Gewindeplatte ein hakenförmiger Kragarm seitlich angeformt sein. Dieser hakenförmige Kragarm kann seitlich über das Unterteil und das Oberteil herausragen, so dass auf den hakenförmigen Kragarm ein Anschlusselement, insbesondere eine Rahmenklemme aufgesteckt und mit einer Schraube befestigt werden kann. Auf diese Weise kann ein Anschluss von Kabeln mit Kontakt zur Anschlusslasche möglich sein, so dass ein direkter Spannungsabgriff ermöglicht wird. Diese Verdrahtung muss bei einem Wandlertausch nicht demontiert werden, da die Befestigung nicht an der Wandlerlasche oder der Anschlusslasche, sondern vielmehr an der Gewindeplatte erfolgt.

Um die Verdrahtung vor Beschädigungen zu schützen, kann an dem Oberteil zumindest eine Kragwand vorhanden sein, die im Bereich des hakenförmigen Kragarms positioniert ist. Vorzugsweise können mehrere Kragwände vorhanden sein, so dass an dem Oberteil eine Einhausung für den hakenförmigen Kragarm gebildet wird. Sofern diese Einhausung auch oberhalb des hakenförmigen Kragarms vorhanden ist, ist auch bei einem Aufdrehen der Schraube der Rahmenklemme ein Verlierschutz der Schraube gewährleistet.

In einer besonders bevorzugten Ausführungsform kann ein gemeinsames Unterteil vorhanden sein, an dem mehrere Oberteile mit einem gewissen gegenseitigen Abstand zueinander befestigt sind. Dabei kann jedes Oberteil mit einem Sicherungselement an dem gemeinsamen Unterteil fixiert werden. Eine solche Ausbildung kann nicht nur für Wandlerbauteile sondern für verschiedene elektromechanische Bauteile vorteilhaft sein, so dass diese Ausführungsform von eigenständiger erfinderischer Bedeutung ist.

In einer bevorzugten Ausführungsform kann an zumindest einem der Oberteile zumindest ein Hakenelement vorhanden sein. In dem gemeinsamen Unterteil kann zumindest eine Vertiefung ausgebildet sein, die die das zumindest eine Hakenelement eintaucht, wenn das Oberteil auf dem gemeinsamen Unterteil aufliegt. In dem gemeinsamen Unterteil kann zumindest ein Kanal ausgebildet sein. In diesen zumindest einen Kanal kann ein Sicherungsstift als Sicherungselement eingeführt werden. Der Sicherungsstift liegt dabei zumindest bereichsweise an der Innenseite des zumindest einen Hakenelements an. Auf diese Weise kann verhindert werden, dass das Oberteil von dem gemeinsamen Unterteil abgehoben werden kann.

Alternativ dazu kann das zumindest eine Hakenelement auch an dem gemeinsamen Unterteil vorhanden sein. Die zumindest eine Vertiefung und der zumindest eine Kanal wären in diesem Fall an dem Oberteil ausgebildet.

In einer vorteilhaften Ausführungsform kann das zumindest eine Hakenelement zumindest bereichsweise eine seitlich offene Nut aufweisen. Der zumindest eine Sicherungsstift kann in diesem Fall in die seitlich offene Nut des zumindest einen Hakenelements eingreifen. Die seitlich offene Nut kann in diesem Fall auch als zusätzliches Führungselement für den Sicherungsstift innerhalb des Kanals dienen.

Gegebenenfalls kann statt des zumindest einen Hakenelements auch zumindest eine geschlossene Öse vorhanden sein. In diesem Fall würde der zumindest eine Sicherungsstift durch die Öffnung der Öse hindurchgeführt werden.

Der zumindest eine Sicherungsstift kann vorzugsweise zumindest einen Rasthebel aufweisen, der parallel zur Längsrichtung des Sicherungsstifts verläuft. Die Rastnase des Rasthebels kann in eine Einkerbung des gemeinsamen Unterteils beziehungsweise des Oberteils einrasten, so dass der Sicherungsstift nicht mehr versehentlich aus dem Kanal entfernt werden kann. Grundsätzlich sind in diesem Zusammenhang zwei unterschiedliche Rastnasen möglich. In einer ersten Variante kann die Rastnase so geformt sein, dass diese in der Einkerbung einrasten kann, um den Sicherungsstift in seiner eingeschobenen Position zu fixieren. Gleichzeitig kann diese Rastnase wieder aus der Einkerbung entfernt werden, um das Oberteil wieder von dem Unterteil entfernen zu können. In einer zweiten Variante kann die Rastnase so geformt sein, dass diese beim erstmaligen Einschieben des Sicherungsstifts in eine längere Einkerbung einrasten kann. Innerhalb dieser Einkerbung kann die Rastnase hin und her verschoben werden, so dass der Sicherungsstift in unterschiedlichen Positionen vorhanden sein kann. Gleichzeitig kann diese Rastnase so geformt sein, dass die Rastnase nicht mehr aus der Einkerbung entfernt werden kann. Der Sicherungsstift kann somit nicht mehr vollständig aus dem Kanal entfernt werden. Dies kann insbesondere sicherstellen, dass der Sicherungsstift nicht verloren gehen kann.

In einer vorteilhaften Ausführungsform können zwei Sicherungsstifte als Sicherungselement vorhanden sein. Entsprechend können auch zwei parallel verlaufende Kanäle in dem gemeinsamen Unterteil beziehungsweise dem Oberteil vorhanden sein. In diesem Fall sollten an dem Oberteil beziehungsweise dem gemeinsamen Unterteil zumindest zwei Hakenelemente vorhanden sein, so dass in Bereich von beiden Kanälen jeweils zumindest ein Hakenelement positioniert werden kann. Vorzugsweise können insgesamt vier Hakenelemente vorhanden sein, so dass im Bereich von jedem Kanal jeweils zwei Hakenelemente positioniert sind.

Die beiden Sicherungsstifte können vorzugweise durch einen Querbalken zu einem U-förmigen Sicherungsbügel verbunden sein. Auf diese Weise ist eine gleichmäßige Befestigung des Oberteils an dem gemeinsamen Unterteil möglich, ohne mehrere Sicherungselemente zu benötigen. Dies reduziert die Gefahr, Bauteile zu verlieren oder die Montage eines Bauteils zu vergessen. Um den Sicherungsbügel möglichst einfach wieder zumindest ein Stück weit aus dem Bauteil entfernen zu können, kann an dem Querbalken eine Einkerbung oder eine Ausnehmung vorhanden sein. In diese Einkerbung oder Ausnehmung kann mit einem geeigneten Werkzeug, insbesondere mit einem Schraubendreher, eingegriffen werden, um den Sicherungsbügel wieder aus den beiden Kanälen herauszuziehen. In diesem Fall kann einer der beiden Sicherungsstifte mit einem Rasthebel mit einer Rastnase nach der oben beschriebenen ersten Variante und der andere der beiden Sicherungsstifte mit einem Rasthebel mit einer Rastnase nach der oben beschriebenen zweiten Variante ausgestattet sein.

Bei einem solchen elektromechanischen Bauteil kann es sich beispielsweise um einen Wandlerbaustein handeln. In diesem Fall kann zwischen dem gemeinsamen Unterteil und jedem Oberteil eine Gewindeplatte vorhanden sein. Entsprechend kann an jedem Oberteil eine Anschlusslasche befestigt sein.

An einem solchen gemeinsamen Unterteil können grundsätzlich auch mehrere unterschiedliche Bauteile in Form von Oberteilen befestigt werden. Die Oberteile müssen in diesem Fall lediglich entsprechende Befestigungsmöglichkeiten aufweisen, so dass diese mittels eines entsprechenden Sicherungsstifts an dem gemeinsamen Unterteil befestigt werden können. Dies ermöglicht auch die schnelle Auswechslung von unterschiedlichen Oberteilen. Durch ein solches Plattformkonzept kann somit eine rasche und unkomplizierte Anpassung an unterschiedliche Anwendungsfälle realisiert werden.

Das gemeinsame Unterteil kann vorzugsweise eine Montageplatte aufweisen, die an zumindest einem Feldprofil befestigt werden kann. An dieser Montageplatte können mehrere erhabene Bereiche ausgebildet sein, an denen jeweils ein Oberteil befestigt werden kann. Um die Montageplatte an einem Feldprofil befestigen zu können, kann an der Unterseite der Montageplatte zumindest ein Rasthaken vorhanden sein, der mit seiner Rastnase an dem Feldprofil verrastet werden kann. Der Rasthaken kann in diesem Fall beispielsweise an der Unterseite des Feldprofils verrastet werden. Alternativ dazu kann der Rasthaken auch an einer Einkerbung des Feldprofils verrastet werden. Auf diese Weise kann eine Befestigung an unterschiedlich dimensionierten Feldprofilen realisiert werden.

Um den Rasthaken lösen zu können, kann an der Rückseite der Rastnase eine Entriegelungsöse vorhanden sein. Die Entriegelungsöse kann mittels eines Werkzeugs wie beispielsweise eines Schraubendrehers nach hinten bewegt werden, so dass die Rastnase frei ist und die Montagplatte von dem Feldprofil entfernt werden kann. Um eine Beschädigung des Rasthakens zu verhindern, kann ein Anschlag für die Entriegelungsöse vorhanden sein. Auf diese Weise kann die Entriegelungsöse und damit auch der Rasthaken nur um eine definierte Strecke bewegt werden. Eine zu starke Biegung des Rasthakens und ein damit einhergehendes Losreißen der Montageplatte von dem Feldprofil kann somit verhindert werden.

In einer vorteilhaften Ausführungsform kann ein entnehmbares Sperrelement vorhanden sein. Dieses Sperrelement kann im Bereich der Rückseite der Rastnase des Rasthakens positioniert werden, um eine Bewegung des Rasthakens zu verhindern. Das Sperrelement ermöglicht daher auch bei größeren Belastungen eine sichere Befestigung der Montageplatte an dem Feldprofil. An dem Sperrelement kann vorzugsweise eine Rastnase angeformt sein. Diese Rastnase kann in eine Vertiefung an der Montageplatte einrasten, um das Sperrelement in seiner Position zu fixieren.

An den Seitenrändern der Montageplatte kann zumindest bereichsweise ein Lochraster vorhanden sein. Durch das Lochraster kann gegebenenfalls eine Schraubbefestigung der Montageplatte an einem Feldprofil oder an einer weiteren Montageplatte vorgenommen werden.

Der oben beschriebene Wandlerbaustein kann vorzugsweise in einer Wandlereinheit mit zumindest einem Messwandler und zumindest einer Wandlerlasche eingesetzt werden. Die zumindest eine Wandlerlasche kann in diesem Fall an der Anschlusslasche des entsprechenden Wandlerbausteins befestigt werden. Dies ermöglicht eine besonders kompakte Anordnung der jeweiligen Wandlereinheiten. Auf diese Weise können darüber hinaus auch mehrere Messwandler besonders kompakt und damit platzsparend angeordnet werden.

Weitere Vorteile und Merkmale der Erfindung sind den in den Ansprüchen ferner angegebenen Merkmalen sowie den nachstehenden Ausführungsbeispielen zu entnehmen.

### KURZE BESCHREIBUNG DER ZEICHNUNG

Die Erfindung wird im Folgenden anhand der in der Zeichnung dargestellten Ausführungsbeispiele näher beschreiben und erläutert. Es zeigen:
- Fig. 1: eine perspektivische Darstellung einer ersten Ausführungsform des zusammengebauten Wandlerbausteins,
- Fig. 2: eine perspektivische Darstellung des Wandlerbausteins gemäß Fig. 1 mit Blick auf die Unterseite des Unterteils und mit teilweise entferntem Sicherungsbügel,
- Fig. 3: eine perspektivische Darstellung des Unterteils des Wandlerbausteins gemäß Fig. 1 und 2 mit Blick auf die zum Oberteil gerichtete Oberseite des Unterteils,
- Fig. 4: eine perspektivische Darstellung des Oberteils des Wandlerbausteins gemäß Fig. 1 und 2 mit Blick auf die Oberseite des Oberteils,
- Fig. 5: eine perspektivische Darstellung des Oberteils gemäß Fig. 4 mit Blick auf die zum Unterteil gerichtete Unterseite des Oberteils,
- Fig. 6: eine perspektivische Darstellung des Sicherungsbügels des Wandlerbausteins gemäß Fig. 1 und 2,
- Fig. 7: einen Längsschnitt durch das Unterteil des Wandlerbausteins gemäß Fig. 3 im Bereich des einen Sicherungsstifts, wobei sich der Sicherungsbügel in seiner eingesetzten Position befindet,
- Fig. 8: einen Längsschnitt gemäß Fig. 7, wobei sich der Sicherungsbügel in seiner teilweise aus dem Kanal entfernten Position befindet,
- Fig. 9: einen Längsschnitt durch das Unterteil des Wandlerbausteins gemäß Fig. 3 im Bereich des anderen Sicherungsstifts, wobei sich der Sicherungsbügel in seiner eingesetzten Position befindet,
- Fig. 10: einen Längsschnitt gemäß Fig. 9, wobei sich der Sicherungsbügel in seiner teilweise aus dem Kanal entfernten Position befindet,
- Fig. 11: eine perspektivische Darstellung der Gewindeplatte gemäß Fig. 1 und 2 mit Blick auf die zum Oberteil gerichtete Oberseite der Gewindeplatte,
- Fig. 12: eine perspektivische Darstellung der Gewindeplatte gemäß Fig. 11 mit Blick auf die Unterseite der Gewindeplatte mit eingesetzten Gewindemuttern,
- Fig. 13: eine perspektivische Darstellung der Anschlusslasche des Wandlerbausteins gemäß Fig. 1 und 2,
- Fig. 14: einen Querschnitt durch den an einer Hutschiene befestigten Wandlerbaustein gemäß Fig. 1 und 2,
- Fig. 15: eine perspektivische Darstellung des Sicherungselements des Wandlerbausteins gemäß Fig. 1 und 2,
- Fig. 16: einen weiteren Querschnitt durch den Wandlerbaustein gemäß Fig. 1 und 2,
- Fig. 17: eine perspektivische Darstellung einer erfindungsgemäßen Wandlereinheit, mit drei übereinander angeordneten Messwandlern, die über Wandlerlaschen an Wandlerbausteinen befestigt sind, welche wiederum auf Hutschienen befestigt sind,
- Fig. 18: eine perspektivische Darstellung einer zweiten erfindungsgemäßen Wandlereinheit mit drei nebeneinander angeordneten Wandlereinheiten, die über Wandlerlaschen an Wandlerbausteinen befestigt sind, welche wiederum über ein gemeinsames Unterteil an Feldprofilen befestigt sind,
- Fig. 19: eine perspektivische Darstellung eines bei der Wandlereinheit gemäß Fig. 15 eingesetzten gemeinsamen Unterteils mit drei Wandlerbausteinen,
- Fig. 20: eine perspektivische Darstellung des gemeinsamen Unterteils gemäß Fig. 19,
- Fig. 21: eine perspektivische Darstellung der Unterseite des gemeinsamen Unterteils gemäß Fig. 20,
- Fig. 22: eine perspektivische Darstellung des Sperrelements zur Befestigung des gemeinsamen Unterteils an einem Feldprofil,
- Fig. 23: einen Querschnitt durch den Randbereich des an einem Feldprofil befestigten gemeinsamen Unterteils,
- Fig. 24: eine perspektivische Darstellung einer zweiten Ausführungsform des erfindungsgemäßen Wandlerbausteins,
- Fig. 25: eine perspektivische Darstellung des Unterteils des Wandlerbausteins gemäß Fig. 24 mit Blick auf die zum Oberteil gerichtete Oberseite des Unterteils,
- Fig. 26: eine perspektivische Darstellung des Sicherungselements des Wandlerbausteins gemäß Fig. 25,
- Fig. 27: eine weitere perspektivische Darstellung des Sicherungselements des Wandlerbaustein gemäß Fig. 26 und
- Fig. 28: einen Querschnitt durch den Wandlerbaustein gemäß Fig. 25.

### WEGE ZUM AUSFÜHREN DER ERFINDUNG

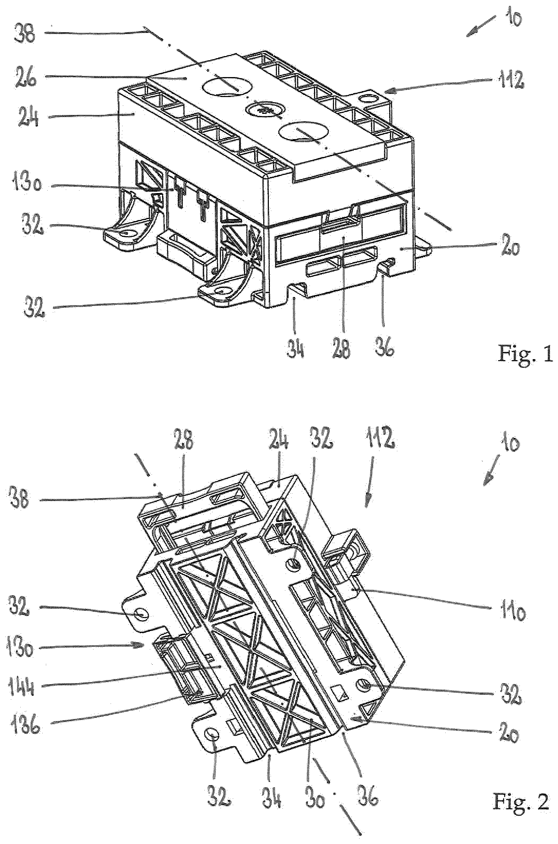

Eine erste Ausführungsform des erfindungsgemäßen Wandlerbausteins 10 ist in Fig. 1 perspektivisch dargestellt. Der Wandlerbaustein 10 besitzt ein Unterteil 20, eine Gewindeplatte 22, ein Oberteil 24 und eine Anschlusslasche 26. Die Befestigung des Oberteils 24 an dem Unterteil 20 erfolgt im vorliegenden Beispielsfall mittels eines Sicherungsbügels 28.

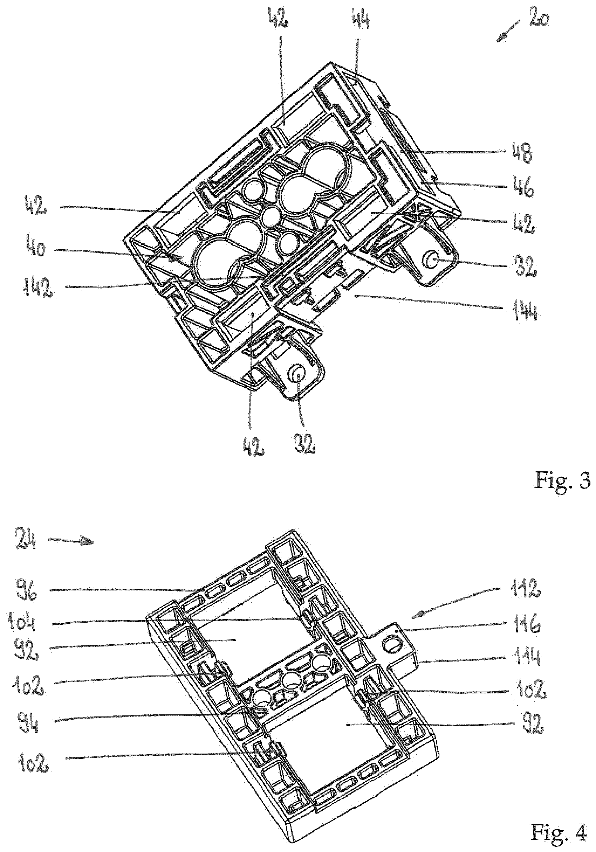

Das Unterteil 20 (siehe insbesondere Fig. 2 und 3) ist rechteckig ausgebildet und weist im vorliegenden Beispielsfall im Bereich seiner Unterseite 30 an seinen beiden einander gegenüber liegenden Seitenrändern jeweils zwei Ösen 32 auf. Über diese Ösen 32 kann das Unterteil 20 an einer Montageplatte mit Bohrungen für eine Schraubbefestigung befestigt werden. Derartige Montageplatten sind weit verbreitet und werden bei Zähler- und Verteilerschränken ebenso wie bei anderen Schaltschränken regelmäßig eingesetzt. Um das Unterteil 20 darüber hinaus auch an einer Hutschiene befestigen zu können, sind in der Unterseite 30 des Unterteils 20 im vorliegenden Beispielsfall zwei kanalartige Einkerbungen 34, 36 vorhanden. Die beiden kanalartigen Einkerbungen 34, 36 verlaufen parallel zueinander und auch parallel zur Längsachse 38 des Wandlerbausteins 10.

An der zum Oberteil 24 gerichteten Oberseite 40 des Unterteils 20 sind im vorliegenden Beispielsfall insgesamt vier Vertiefungen 42 ausgebildet. Die Vertiefungen 42 sind jeweils im Bereich der beiden Seitenränder angeordnet und entlang der Längsachse 38 des Wandlerbausteins 10 ausgerichtet. Die Vertiefungen 42 enden in zwei Kanälen 44, 46 die jeweils parallel zur Längsachse 38 des Wandlerbausteins 10 verlaufen. An einer der beiden Seitenkanten sind die beiden Kanäle 44, 46 durch eine Einkerbung 48 miteinander verbunden.

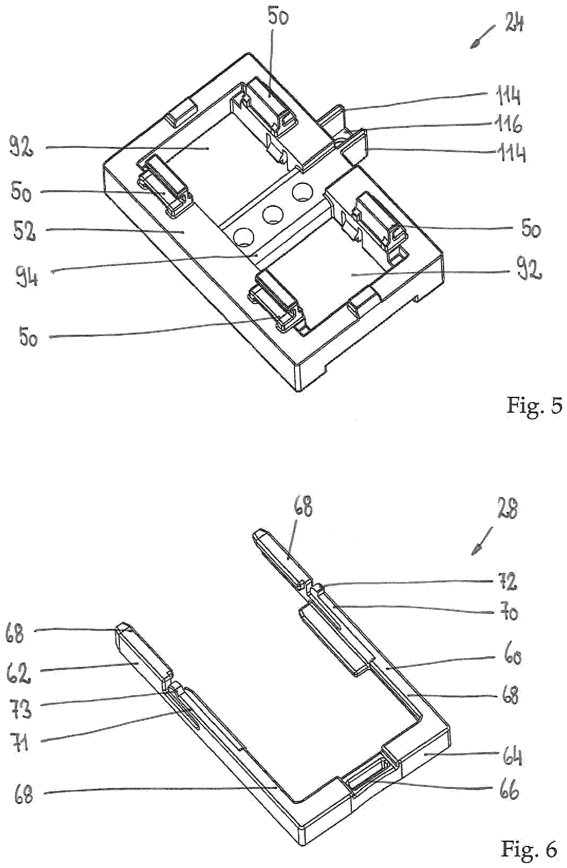

In die Vertiefungen 42 können Hakenelemente 50, die an der Unterseite 52 des Oberteils 24 vorhanden sind (siehe Fig. 5) eingesteckt werden. Die Hakenelemente 50 sind im vorliegenden Beispielsfall jeweils nach außen offen. Im Gegensatz dazu könnten die Hakenelemente 50 auch nach innen offen ausgebildet sein. Die Hakenelemente 50 sind jeweils so ausgebildet, dass das freie Ende des Hakenelements 50 im Bereich der beiden Kanäle 44, 46 positioniert ist, wenn das Oberteil 24 auf dem Unterteil 20 aufliegt.

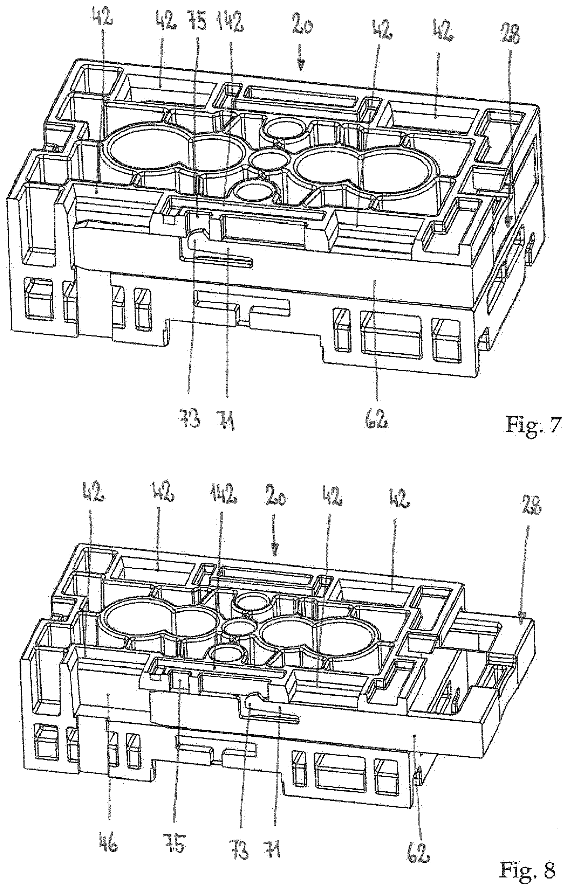

Um das Oberteil 24 an dem Unterteil 20 befestigen zu können, kann der Sicherungsbügel 28 (siehe Fig. 6) von der Seite der Einkerbung 48 her in die beiden Kanäle 44, 46 des Unterteils 20 eingeführt werden (siehe insbesondere Fig. 7 bis 10). Der Sicherungsbügel 28 besitzt zwei Sicherungsstifte 60, 62, die über einen Querbalken 64 miteinander verbunden werden. Der Querbalken 64 kommt dabei in der Einkerbung 48 zu liegen, so dass der Sicherungsbügel 28 vollständig in das Unterteil 20 eingeführt werden kann. An dem Querbalken 64 des Sicherungsbügels 28 ist im vorliegenden Beispielsfall eine Einkerbung 66 vorhanden. In diese Einkerbung 66 kann mit einem geeigneten Werkzeug, beispielsweise mit einem Schraubendreher, eingegriffen werden, um den Querbalken 64 und damit den Sicherungsbügel 28 wieder ein Stück weit aus dem Unterteil 20 herausziehen zu können.

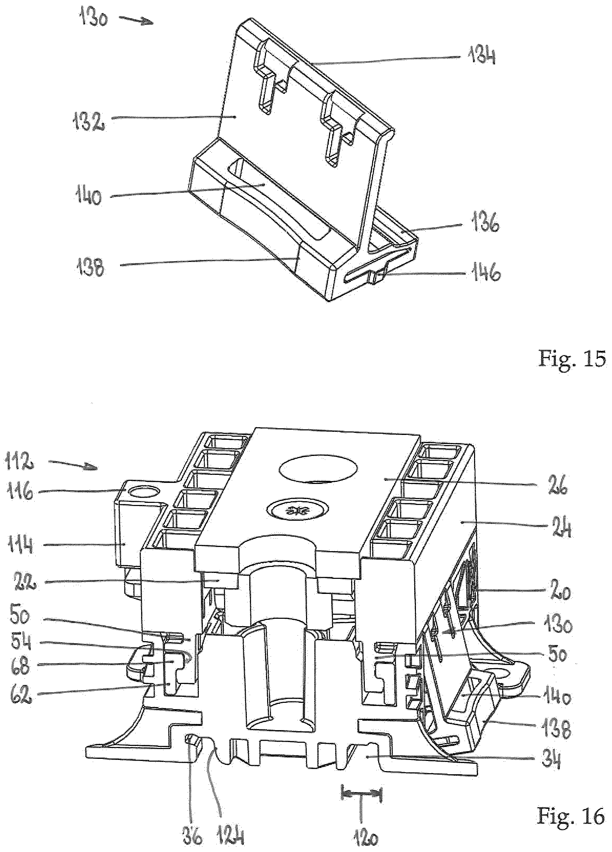

Die beiden Sicherungsstifte 60, 62 weisen im vorliegenden Beispielsfall einen hakenförmigen Querschnitt auf (siehe insbesondere Fig. 16). Beim Einschieben des Sicherungsbügels 28 in die beiden Kanäle 44, 46 werden die beiden Sicherungsstifte 60, 62 mit ihren oberen Umbiegungen 68 somit oberhalb der Hakenelemente 50 des Oberteils 24 positioniert. Das Oberteil 24 kann dadurch bei eingesetztem Sicherungsbügel 28 nicht mehr von dem Unterteil 20 entfernt werden. Im vorliegenden Beispielsfall weisen die beiden Hakenelemente 50 des Oberteils 24 jeweils eine seitlich offene Nut 54 auf (siehe insbesondere Fig. 16). Die seitlich offene Nut 54 ist dabei jeweils nach außen gerichtet. In diese Nut 54 kann die obere Umbiegung 68 der beiden Sicherungsstifte 60, 62 eingreifen, so dass eine zusätzliche Führung der Sicherungsstifte 60, 62 gegeben ist.

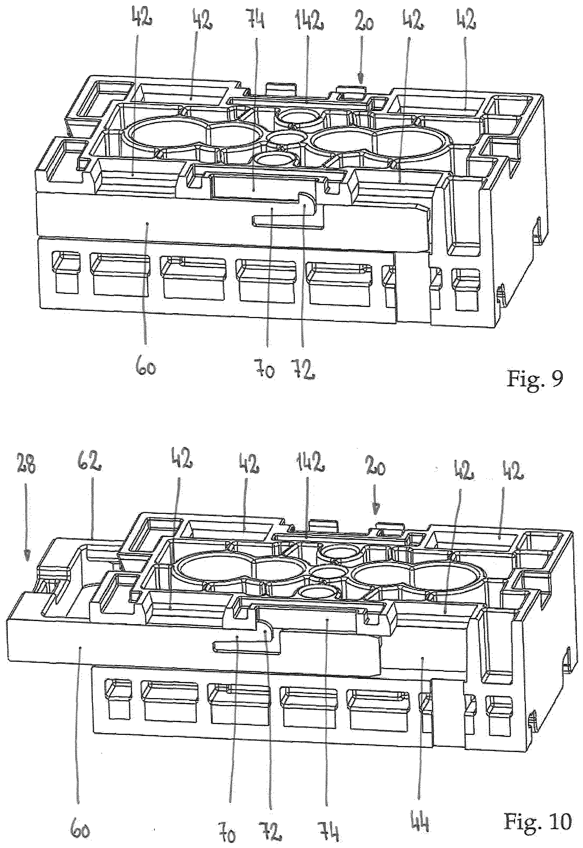

Um die Sicherungsstifte 60, 62 zusätzlich innerhalb der Kanäle 44, 46 lagezufixieren, ist an den beiden Sicherungsstiften 60, 62 im vorliegenden Beispielsfall jeweils ein Rasthebel 70, 71 angeformt. Die beiden Rasthebel 70, 71 weisen jeweils eine nach oben zum Oberteil 24 gerichtete Rastnase 72, 73 auf (siehe Fig. 6 bis 10). Im vorliegenden Beispielsfall sind die Rastnasen 72, 73 etwas unterschiedlich geformt. Die Rastnase 72 des Rasthebels 70 des Sicherungsstifts 60 ist an ihrer Rückseite gerade ausgebildet. Wird der Sicherungsstift 60 in den Kanal 44 eingeführt, kann die Rastnase 72 in eine längliche Einkerbung 74 an der Oberseite des Kanals 44 einrasten. Innerhalb dieser Einkerbung 74 kann die Rastnase 72 und damit auch der Sicherungsstift 60 ein Stück weit hin und her verschoben werden (siehe Fig. 9 und 10). Durch die gerade Rückseite der Rastnase 72 kann der Sicherungsstift 60 jedoch nicht mehr vollständig aus dem Kanal 44 entfernt werden, da die Rastnase 72 nicht mehr aus der Einkerbung 74 entfernt werden kann. Eine solche Ausbildung der Rastnase 72 kann somit als Verlierschutz für den Sicherungsstift 60 und damit auch für den Sicherungsbügel 28 dienen. Die Rastnase 73 des Rasthebels 71 des Sicherungsstifts 62 ist dagegen beidseitig abgeschrägt ausgebildet. Wird der Sicherungsstift 62 in den Kanal 46 eingeführt, kann die Rastnase 73 in eine Einkerbung 75 an der Oberseite des Kanals 46 einrasten. Diese Einkerbung 75 ist relativ kurz ausgebildet, so dass keine Bewegung des Sicherungsstifts 62 in Längsrichtung mehr möglich ist. Der Sicherungsstift 62 und damit der Sicherungsbügel 28 wird somit in seiner eingeschobenen Position fixiert, so dass das Oberteil 24 nicht vom Unterteil 20 entfernt werden kann. Gleichzeitig kann die Rastnase 73 wieder aus der Einkerbung 75 entfernt werden, wenn der Sicherungsbügel 28 mit Hilfe der Einkerbung 66 an dem Querbalken 64 ein Stück weit aus dem Unterteil 20 herausgezogen wird. Dadurch kann auch das Oberteil 24 wieder von dem Unterteil 20 entfernt werden.

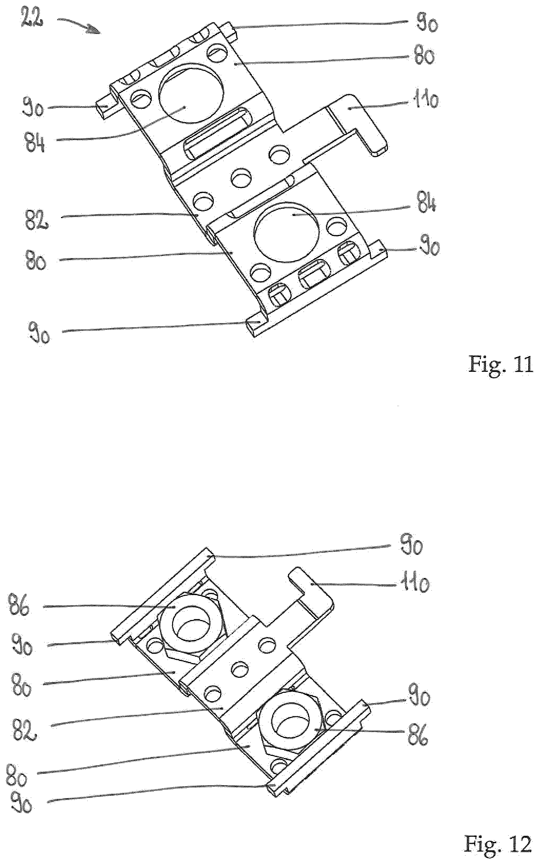

Zwischen dem Unterteil 20 und dem Oberteil 24 wird eine Gewindeplatte 22 (siehe Fig. 11 und 12) positioniert. Die Gewindeplatte 22 weist zwei etwa rechteckige erhabene Bereiche 80 auf, die durch einen Verbindungssteg 82 verbunden sind. In den beiden erhabenen Bereichen 80 ist im vorliegenden Beispielsfall jeweils ein Durchbruch 84 vorhanden (siehe Fig. 11). In beide Durchbrüche 84 kann jeweils eine Gewindemutter 86 eingepresst werden, wie dies in Fig. 12 dargestellt ist. Mittels der Gewindemuttern 86 kann eine Anschlussschraube an der Gewindeplatte 22 befestigt werden. Im Gegensatz zu dem hier dargestellten Ausführungsbeispiel könne die beiden Durchbrüche 84 auch jeweils ein angeformtes Innengewinde aufweisen, um die Anschlussschrauben an der Gewindeplatte 22 befestigen zu können. Darüber hinaus wäre es auch möglich, die Gewindemuttern 86 lediglich in die Durchbrüche 84 einzulegen, ohne diese einzupressen.

Die Gewindeplatte 22 weist im vorliegenden Beispielsfall vier Kragstege 90 auf, von denen jeweils zwei an dem freien Rand der beiden Erhebungen 80 angeordnet sind. Die Kragstege 90 liegen im montierten Zustand des Wandlerbausteins 10 unterhalb des Oberteils 24, und dienen somit als Gegenlager für die Anschlussschrauben 88. Die beiden erhabenen Bereiche 80 der Gewindeplatte 22 sind im montierten Zustand in zwei Ausnehmungen 92 des Oberteils 24 angeordnet. Der Verbindungssteg 82 der Gewindeplatte 22 liegt dabei unterhalb eines Steges 94 des Oberteils 24. Durch diesen Steg 94 werden die beiden Ausnehmungen 92 des Oberteils 24 voneinander getrennt. Der Verbindungssteg 82 dient somit ebenfalls als Gegenlager für die Anschlussschrauben.

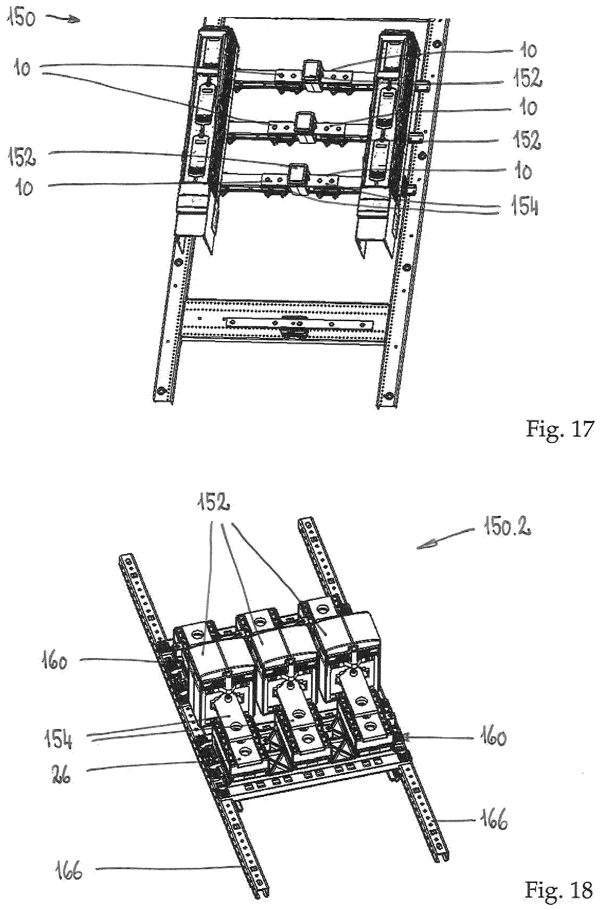

Die erhabenen Bereiche 80 der Gewindeplatte 22 liegen im montierten Zustand des Wandlerbausteins 10 an der Unterseite der Anschlusslasche 26 an. Dadurch wird eine Verbindung und damit auch eine Kontaktierung von der Anschlusslasche 26 zur Gewindeplatte 22 hergestellt. Die Anschlusslasche 26 kann in einer Vertiefung 96 in der Oberseite des Oberteils 24 positioniert werden. Die Anschlusslasche 26 ist somit verdrehsicher an dem Oberteil 24 fixiert, so dass keine weitere Verdrehsicherung erforderlich ist. Die Anschlusslasche 26 ist im vorliegenden Beispielsfall als Kupferplatte ausgebildet. Die Anschlusslasche 26 weist zwei Durchbrüche 98 auf, die mit den Durchbrüchen 84 der Gewindeplatte 22 fluchten. Mittels der Durchbrüche 98 können Anschlussschrauben an der Gewindeplatte 22 befestigt werden. Mittels der Anschlussschrauben können verschiedene elektronische oder elektromechanische Bauteile an der Anschlusslasche 26 befestigt werden, insbesondere auch eine Wandlerlasche 154 (siehe Fig. 17 und 18).

Zwischen den beiden Durchbrüchen 98 ist im vorliegenden Beispielsfall eine weitere Ausnehmung 100 vorhanden. In die Ausnehmung 100 kann eine hier nicht dargestellte Senkschraube eingeführt werden. Diese Senkschraube kann in das Oberteil 24 eingeschraubt werden, so dass die Anschlusslasche 26 vor der eigentlichen Montage gesichert ist und nicht verloren gehen kann. Ein solcher Verlierschutz ist insbesondere bei einem Transport des noch zu montierenden Wandlerbausteins 10 von Bedeutung. Im Gegensatz zu dem hier dargestellten Ausführungsbeispiel könnten auch weitere zusätzliche Ausnehmungen 100 vorgesehen werden. Diese Ausnehmungen 100 könnten neben dem oben beschriebenen Verlierschutz beispielsweise auch einer zusätzlichen Kontaktierung der Gewindeplatte 22 dienen. Darüber hinaus wäre es auch möglich, mittels einer der zusätzlichen Ausnehmungen eine weitere Leiterbahn zwischen der Gewindeplatte 22 und der Anschlusslasche 26 zu befestigen.

Um die Gewindeplatte 22 bereits vor der eigentlichen Montage des Wandlerbausteins 10 vorfixieren zu können, ist im Bereich der Ausnehmungen 92 des Oberteils 24 jeweils ein Rasthaken 102 vorhanden. Die Rastnase 104 des Rasthakens 102 rastet unterhalb des erhabenen Bereichs 80 der Gewindeplatte 22 ein, so dass die Gewindeplatte 22 an dem Oberteil 24 befestigt werden kann. Anschließend kann das Oberteil 24 mit der Gewindeplatte 22 auf dem Unterteil 20 positioniert und dort mittels des Sicherungsbügels 28 fixiert werden.

An dem Verbindungssteg 82 der Gewindeplatte 22 ist im vorliegenden Beispielsfall ein hakenförmiger Kragarm 110 einteilig angeformt. Auf den hakenförmigen Kragarm 110 kann beispielsweise eine Rahmenklemme 118 aufgeschoben und mittels einer Schraube fixiert werden (siehe Fig. 10). Der hakenförmige Kragarm 110 ragt über das Unterteil 20 und das Oberteil 24 über, so dass auf diese Weise beispielsweise ein Kabel direkt an der Gewindeplatte 22 angeschlossen und damit kontaktiert werden kann. Im Gegensatz zu dem hier dargestellten Ausführungsbeispiel könnte der hakenförmige Kragarm 110 auch als separates Bauteil ausgebildet sein. Der hakenförmige Kragarm 110 könnte in diesem Fall teilweise oberhalb der Gewindeplatte 22 angeordnet sein, so dass ein Kontakt zwischen der Gewindeplatte 22 und dem hakenförmigen Kragarm 110 möglich ist.

Um die an dem hakenförmigen Kragarm 110 angeschlossene Verbindung zu schützen, ist im vorliegenden Beispielsfall eine Einhausung 112 vorhanden, die um den hakenförmigen Kragarm 110 herum angeordnet ist. Im vorliegenden Beispielsfall weist die Einhausung 112 zwei senkrechte Kragwände 114 auf, die jeweils neben dem hakenförmigen Kragarm 110 angeordnet sind. Darüber hinaus ist eine waagrechte Kragwand 116 vorhanden, die als Dach der Einhausung 112 dient. Auf diese Weise kann auch ein Verlierschutz der Schraube der Rahmenklemme 118 realisiert werden. Im Gegensatz zu dem hier dargestellten Ausführungsbeispiel könnte auf die waagrechte Kragwand 116 auch verzichtet werden.

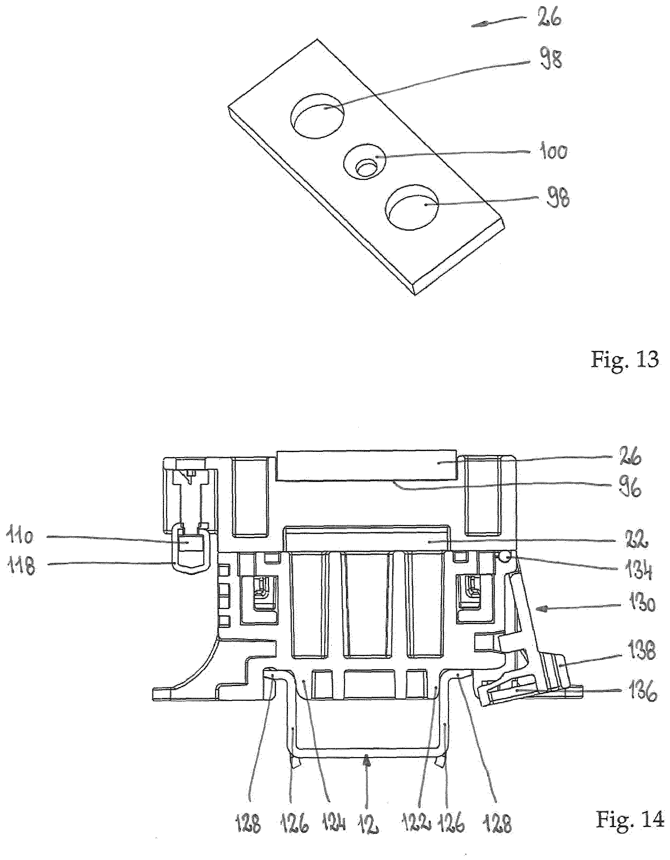

Der Wandlerbaustein 10 kann zunächst vollständig montiert werden, bevor eine Befestigung des Wandlerbausteins 10 an einem geeigneten Montageelement erfolgt. Bei einem solchen Montageelement kann es sich beispielsweise um eine Montageplatte mit Bohrungen für eine Schraubbefestigung oder auch um eine Hutschiene 12 (siehe Fig. 14) handeln. Alternativ dazu kann auch zunächst lediglich das Unterteil 20 des Wandlerbausteins 10 an dem Montageelement befestigt werden. In diesem Fall würde die Montage des Wandlerbausteins 10 erst nach der Befestigung des Unterteils 20 an dem Montageelement erfolgen.

Zur Befestigung des Wandlerbausteins 10 an einer Montageplatte können die Ösen 32 des Unterteils 20 verwendet werden. Zur Befestigung des Wandlerbausteins 10 an einer Hutschiene dienen dagegen die beiden kanalartigen Einkerbungen 34, 36 des Unterteils 20.

Die beiden kanalartigen Einkerbungen 34, 36 weisen einen solchen gegenseitigen Abstand auf, dass diese über die Seitenwände 126 einer Hutschiene 12 gestülpt werden können. Im vorliegenden Beispielsfall weist eine der beiden Einkerbungen 34 einen rechteckigen Querschnitt auf. Die Breite 120 (siehe Fig. 16) dieser kanalartigen Einkerbung 34 ist so gewählt, dass die Seitenwand 126 einer Hutschiene 12 mit ihrer oberen Umbiegung 128 in dieser kanalartigen Einkerbung 34 positioniert werden kann. Die Seitenwand 126 der Hutschiene 12 kann in diesem Fall an der inneren Innenwand 122 der kanalartigen Einkerbung 34 anliegen. Die zweite der beiden kanalartigen Einkerbungen 36 weist dagegen einen hakenförmigen Querschnitt auf. Dieser hakenförmige Querschnitt ist an die Seitenwand 126 der Hutschiene 12 und deren oberen Umbiegung 128 angepasst, jedoch etwas aufgeweitet. Auf diese Weise kann das Unterteil 20 des Wandlerbaustein 10 mit seiner hakenförmigen Einkerbung 36 über die Seitenwand 126 der Hutschiene 12 geführt und von oben auf die Hutschiene 12 geschwenkt werden. Durch die rechteckige Form der ersten Einkerbung 34 kann das Unterteil 20 über die zweite Seitenwand 126 der Hutschiene 12 gestülpt werden. Die zweite Seitenwand 126 der Hutschiene 12 kann dabei an der inneren Innenwand 124 der hakenförmigen Einkerbung 36 anliegen. Da das Unterteil 20 auf diese Weise mit dem mittleren Bereich der Unterseite 30 an den Seitenwänden 126 der Hutschiene 12 anliegt, ist eine Verdrehung des Unterteils 20 in der Hutschiene 12 nicht möglich. Dies sorgt für eine zusätzliche Verdrehsicherung des gesamten Wandlerbausteins 10.

Um das Unterteil 20 und damit auch den Wandlerbaustein 10 an der Hutschiene 12 zu fixieren und die Möglichkeit eines Verschiebens des Wandlerbausteins 10 entlang der Längsachse der Hutschiene 12 zu verhindern, ist an dem Unterteil 20 im vorliegenden Beispielsfall ein Sicherungselement 130 vorhanden (siehe Fig. 14 und 15). Das Sicherungselement 130 besitzt eine Seitenwand 132, deren oberes freies Ende als Welle 134 ausgebildet ist. Am unteren Ende der Seitenwand 132 ist ein Kragelement 136 einteilig angeformt, das etwa senkrecht zur Seitenwand 132 ausgerichtet ist. Das Kragelement 136 weist an seiner Rückseite einen kurzen Kragsteg 138 auf, so dass das Sicherungselement 130 insgesamt etwa T-förmig ausgebildet ist. In dem Kragsteg 138 ist eine Einkerbung 140 vorhanden. In die Einkerbung 140 kann mit einem geeigneten Werkzeug, beispielsweise mit einem Schraubendreher, eingegriffen werden, um das Sicherungselement 130 zu bewegen.

Das Sicherungselement 130 kann mit seiner Welle 134 in eine Vertiefung 142 im Bereich der Oberseite 40 des Unterteils 20 eingelegt werden. Diese Vertiefung 142 ist an einer der beiden Seitenwänden des Unterteils 20 vorhanden und etwa mittig des Unterteils 20 zwischen den beiden Ösen 32 und den beiden Vertiefungen 42 für die Hakenelemente 50 angeordnet. Die Vertiefung 142 ist dabei an derjenigen Seite des Unterteils 20 vorhanden, an der sich die kanalartige Einkerbung 34 mit dem rechteckigen Querschnitt befindet. Durch das an dem Unterteil 20 befestigte Oberteil 24 wird das Sicherungselement 130 in der Vertiefung 142 gesichert. Dadurch kann das Sicherungselement 130 noch um die Welle 134 verschwenkt werden, jedoch nicht mehr vollständig von dem Unterteil 20 entfernt werden. Um das Unterteil 20 an der Hutschiene 12 zu befestigen, muss das Sicherungselement 130 zunächst etwas nach außen verschwenkt werden, so dass das I<ragelement 136 nicht in den Bereich der kanalartigen Einkerbung 34 eingreift (AUF-Position). Befindet sich das Unterteil 20 und damit der Wandlerbaustein 10 in der gewünschten Position auf der Hutschiene 12, kann das Sicherungselement 130 in Richtung der Hutschiene 12 verschwenkt werden, so dass die Seitenwand 132 des Sicherungselements 130 an der Seitenwand des Unterteils 20 anliegt. Das Kragelement 136 des Sicherungselements 130 wird dabei durch eine Ausnehmung 144 an der Unterseite 30 des Unterteils 20 in den Bereich der kanalartigen Einkerbung 34 verschwenkt. Dadurch wird das Kragelement 136 unterhalb der Umbiegung 128 der Seitenwand 126 der Hutschiene 12 positioniert. Auf diese Weise wird die Seitenwand 126 der Hutschiene 12 in diesem Bereich klemmend gehalten, so dass eine Lagefixierung des Unterteils 20 und damit des Wandlerbausteins 10 erreicht wird (ZU-Position).

Um das Sicherungselement 130 in der ZU-Position zu fixieren, ist an dem Kragelement 136 beidseitig jeweils eine seitliche Rastnase 146 vorhanden. Diese Rastnase 146 kann in eine hier nicht darstellte Vertiefung des Unterteils 20 einrasten, um das Kragelement in der ZU-Position zu fixieren. Um das Sicherungselement 130 wieder aus der ZU-Position zu lösen und in die AUF-Position zu überführen, kann mit einem Werkzeug in die Einkerbung 140 an dem Kragsteg 138 eingegriffen werden. Dadurch werden die Rastnasen 146 aus den Vertiefungen gezogen und das Sicherungselement 130 kann gelöst werden.

Das Sicherungselement 130 ist lediglich in Verbindung mit einer Hutschiene 12 erforderlich. Sofern keine Befestigung an einer Hutschiene 12 vorgenommen werden soll, kann auf das Sicherungselement 130 verzichtet werden, ohne die Funktion des Wandlerbausteins 10 zu beeinträchtigen. Dies kann beispielsweise bei der Befestigung des Wandlerbausteins 10 an einer Montageplatte oder an einem Feldprofil der Fall sein.

Mit einem solchen erfindungsgemäßen Wandlerbaustein 10 kann beispielsweise die in Fig. 17 dargestellte Wandlereinheit 150 realisiert werden. Die Wandlereinheit 150 besitzt im vorliegenden Beispielsfall drei Messwandler 152, die übereinander angeordnet sind. Die Wandlerlaschen 154 sind beidseitig der Messwandler 152 jeweils an einem Wandlerbaustein 10 befestigt. Die Wandlerbausteine 10 sind jeweils an Hutschienen 12 befestigt.

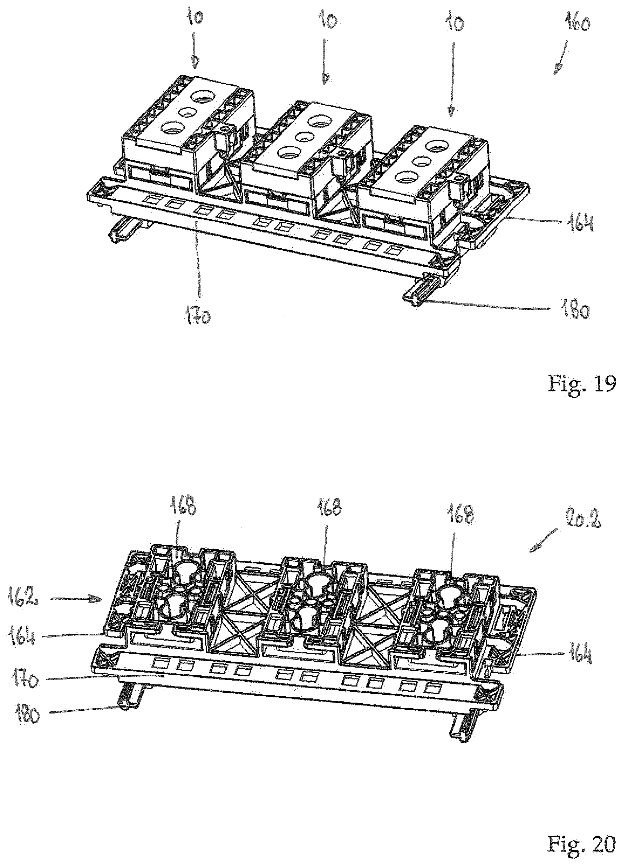

Eine alternative Wandlereinheit 150.2 ist in Fig. 18 dargestellt. Die Wandlereinheit 150.2 besitzt im vorliegenden Beispielsfall ebenfalls drei Messwandler 152, die jedoch nebeneinander angeordnet sind. Die Wandlerlaschen 154 sind beidseitig der Messwandler 152 jeweils mittels einer Anschlussschraube an einem elektromechanischen Bauteil 160 (siehe insbesondere Fig. 19) befestigt, wobei jedes elektromechanisches Bauteil 160 drei Wandlerbausteine 10 umfasst.

Jedes elektromechanische Bauteil 160 besitzt eine Montageplatte 162, die etwa rechteckig ausgebildet ist. Mit ihren beiden Schmalseiten 164 kann die Montageplatte 162 jeweils an einem Feldprofil 166 befestigt werden. An der Montageplatte 162 sind im vorliegenden Beispielsfall drei erhabene Bereiche 168 ausgebildet. Die Oberseite der erhabenen Bereiche 168 entspricht jeweils der Oberseite eines Unterteils 20, so dass an jedem der erhabenen Bereiche 168 ein Oberteil 24 mit einer Gewindeplatte 22 befestigt werden kann. Die Befestigung kann dabei mit einem Sicherungsbügel 28 erfolgen, wie dies oben bereits beschreiben wurde. Die Montageplatte 162 mit den erhabenen Bereichen 168 kann somit als gemeinsames Unterteil 20.2 für mehrere Oberteile 24 dienen.

Im Gegensatz zu dem hier dargestellten Ausführungsbeispiel könnten an dem gemeinsamen Unterteil 20.2 auch andere Oberteile befestigt werden. Auf diese Weise können unterschiedliche elektromechanische Bauteile 160 realisiert werden. Dabei wäre es auch möglich, unterschiedliche Oberteile an einem gemeinsamen Unterteil 20.2 zu befestigen. Dies ermöglicht eine einfache und rasche Anpassung des elektromechanischen Bauteils 160 an unterschiedliche Anwendungsfälle.

Die Montageplatte 162 des gemeinsamen Unterteils 20.2 weist an ihren beiden Längsseiten jeweils ein Lochraster 170 für eine LexCom-Home Schnellbefestigung auf. Dadurch können weitere elektromechanische Bauteile an der Montageplatte 162 befestigt werden, so dass eine weitere Anpassungsmöglichkeit an unterschiedliche Gegebenheiten realisiert werden kann.

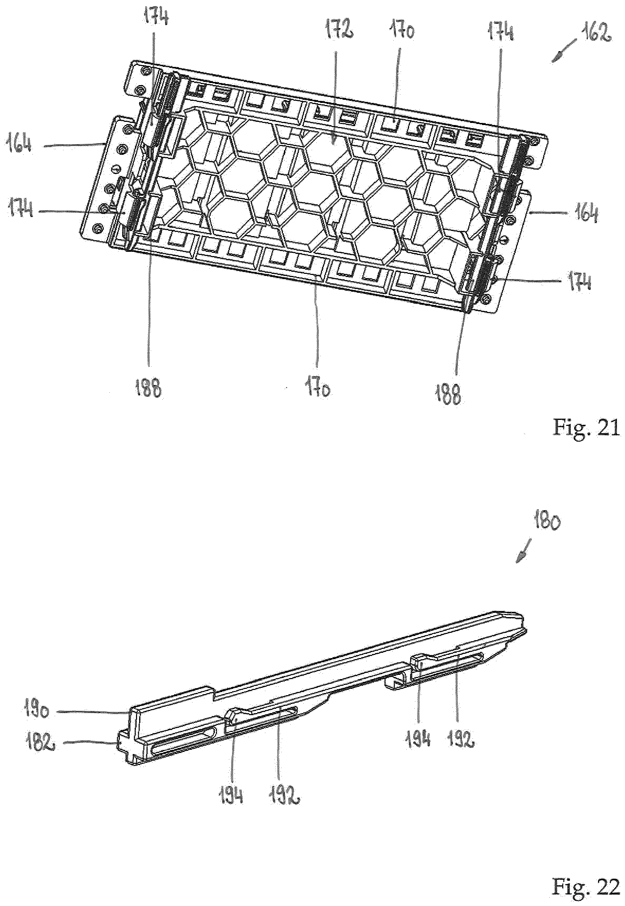

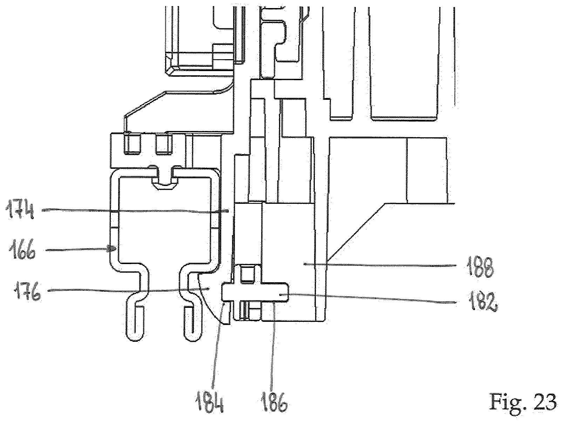

Um die Montageplatte 162 an dem Feldprofil 166 zu befestigen, sind an der Unterseite 172 der Montageplatte 162 entlang der Schmalseiten 164 jeweils zwei Rasthaken 174 einteilig angeformt (siehe Fig. 21). Die Rastnase 176 des Rasthakens 174 kann beispielsweise an der Unterseite des Feldprofils 166 einrasten. Bei größeren Zugbelastungen an der Montageplatte 162 können die Rastnasen 176 als alleinige Befestigung nicht ausreichend sein, da die Rastnasen 176 durch die Zugbelastung gelöst werden können. Daher ist ein Sperrelement 180 (siehe Fig. 22) vorhanden, durch das die Rastnasen 176 in ihrer verrasteten Position lagefixiert werden können (siehe auch Fig. 23).

Das Sperrelement 180 ist im vorliegenden Beispielsfall stiftförmig ausgebildet, so dass mit einem Sperrelement 180 alle Rastnasen 176 entlang einer der beiden Schmalseiten 164 gesichert werden können. Auf diese Weise sind zwei Sperrelemente 180 für die Sicherung der gesamten Montageplatte 162 ausreichend.

Im vorliegenden Beispielsfall weist das Sperrelement 180 einen etwa kreuzförmigen Querschnitt auf. Mit seinem horizontalen Riegel 182 greift das Sperrelement 180 einerseits in eine Nut 184 an der Rückseite der Rastnase 176 und andererseits in eine Nut 186 in einer von der Unterseite 172 der Montageplatte 162 auskragende Wand 188 ein. Die Wand 188 ist im vorliegenden Beispielsfall lediglich im Bereich der Rasthaken 174 vorhanden. Es wäre jedoch auch möglich, die Wand 188 über die gesamte Schmalseite 164 der Montageplatte 162 vorzusehen. Durch den horizontalen Riegel 182 wird die Rastnase 176 in ihrer verrasteten Position lagefixiert, so dass kein versehentliches Lösen der Rastnase 176 aufgrund zu großer Zugbelastung möglich ist.

Darüber hinaus ist ein vertikaler Riegel 190 des Sperrelements 180 vorhanden. Im vorliegenden Beispielsfall sind neben dem vertikalen Riegel 190 zwei Rasthebel 192 mit einer Rastnase 194 angeformt, die entlang des horizontalen Riegels 182 angeordnet sind. Die Rastnasen 194 der Rasthebel 192 können in hier nicht dargestellte Vertiefungen der Montageplatte 162 einrasten, um das Sperrelement 180 zu fixieren. Das Sperrelement 180 kann sich daher nicht versehentlich von der Montagplatte 162 lösen.

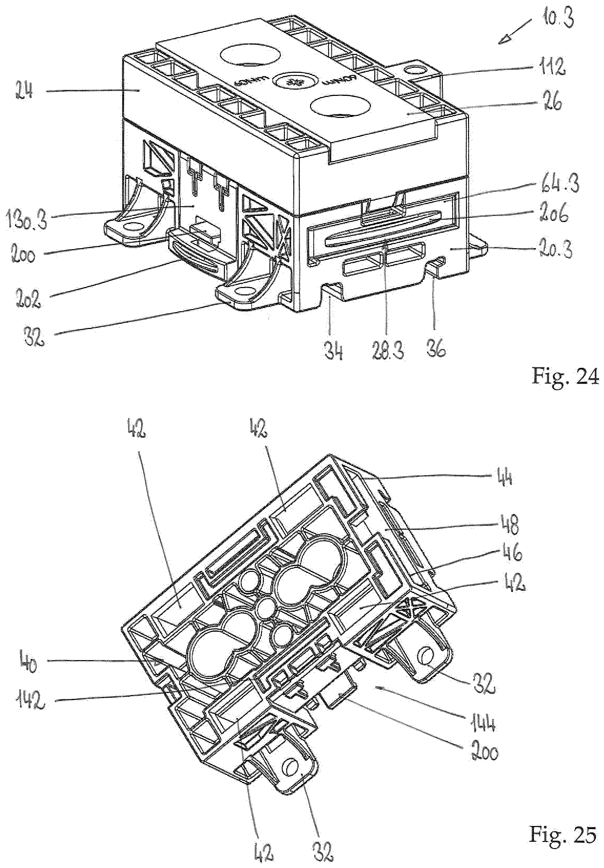

Eine zweite Ausführungsform des erfindungsgemäßen Wandlerbausteins 10.3 ist in Fig. 25 perspektivisch dargestellt. Der Wandlerbaustein 10.3 besitzt ein Unterteil 20.3, eine Gewindeplatte 22, ein Oberteil 24 und eine Anschlusslasche 26. Die Befestigung des Oberteils 24 an dem Unterteil 20.3 erfolgt im vorliegenden Beispielsfall mittels eines Sicherungsbügels 28.3.

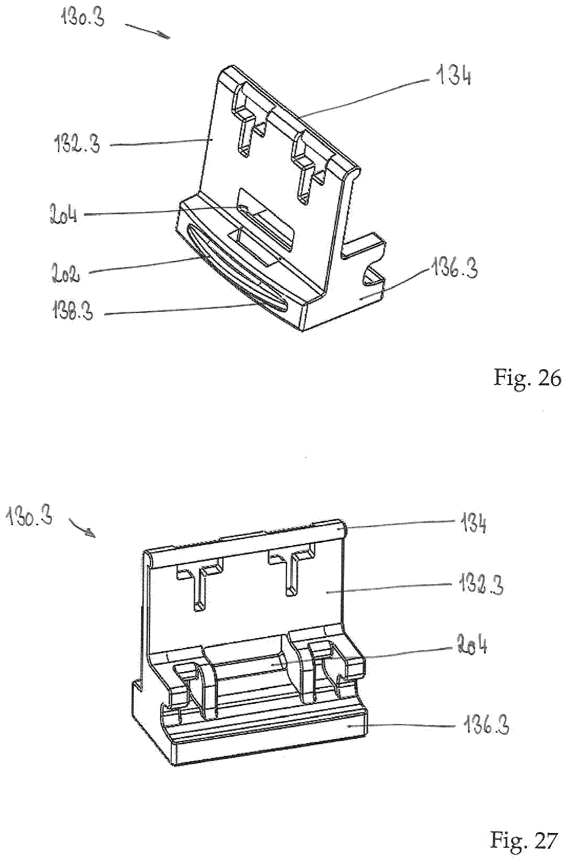

Das Unterteil 20 (siehe insbesondere Fig. 25) unterscheidet sich von dem Unterteil 20 gemäß Fig. 1 bis 16 insbesondere durch den seitlichen Rasthaken 200, der zur Fixierung des Sicherungselements 130.2 (siehe Fig. 26 und 27) dient. Das Sicherungselement 130.3 besitzt eine Seitenwand 132.3, deren oberes freies Ende als Welle 134 ausgebildet ist. Am unteren Ende der Seitenwand 132.3 ist ein Kragelement 136.3 einteilig angeformt, das etwa senkrecht zur Seitenwand 132.3 ausgerichtet ist. Das Kragelement 136.3 weist an seiner Rückseite ein Griffelement 202 auf, so dass das Sicherungselement 130.3 insgesamt etwa T-förmig ausgebildet ist. Mittels des Griffelements 202 kann das Sicherungselement 130.3 ein Stück weit um die Welle 134 verschwenkt werden.

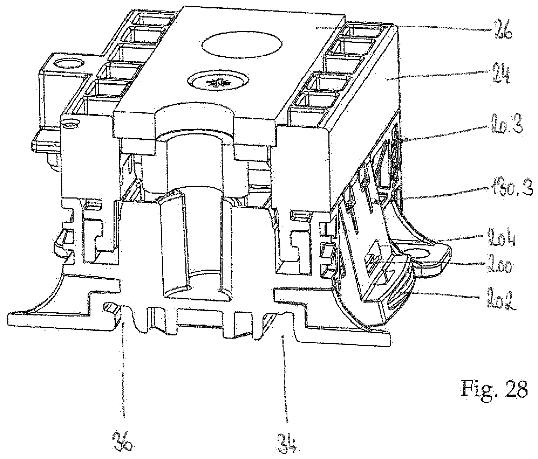

Das Sicherungselement 130.3 kann mit seiner Welle 134 in eine Vertiefung 142 im Bereich der Oberseite 40 des Unterteils 20.3 eingelegt werden. Diese Vertiefung 142 ist an einer der beiden Seitenwänden des Unterteils 20.3 vorhanden und etwa mittig des Unterteils 20.3 zwischen den beiden Ösen 32 und den beiden Vertiefungen 42 für die Hakenelemente 50 angeordnet. Die Vertiefung 142 ist dabei an derjenigen Seite des Unterteils 20.3 vorhanden, an der sich die kanalartige Einkerbung 34 mit dem rechteckigen Querschnitt befindet. Durch das an dem Unterteil 20.3 befestigte Oberteil 24 wird das Sicherungselement 130.3 in der Vertiefung 142 gesichert. Dadurch kann das Sicherungselement 130.3 noch um die Welle 134 verschwenkt werden, jedoch nicht mehr vollständig von dem Unterteil 20.3 entfernt werden. Um das Unterteil 20.3 an der Hutschiene 12 zu befestigen, muss das Sicherungselement 130.3 zunächst etwas nach außen verschwenkt werden, so dass das Kragelement 136.3 nicht in den Bereich der kanalartigen Einkerbung 34 eingreift (AUF-Position, siehe Fig. 28). Befindet sich das Unterteil 20.3 und damit der Wandlerbaustein 10.3 in der gewünschten Position auf der Hutschiene 12, kann das Sicherungselement 130.3 in Richtung der Hutschiene 12 verschwenkt werden, so dass die Seitenwand 132.3 des Sicherungselements 130.3 an der Seitenwand des Unterteils 20.3 anliegt. Das Kragelement 136.3 des Sicherungselements 130.3 wird dabei durch eine Ausnehmung 144 an der Unterseite 30 des Unterteils 20.3 in den Bereich der kanalartigen Einkerbung 34 verschwenkt. Dadurch wird das Kragelement 136.3 unterhalb der Umbiegung 128 der Seitenwand 126 der Hutschiene 12 positioniert. Der Rasthaken 200 des Unterteils 20.3 greift dabei durch eine in der Seitenwand 132.3 des Sicherungselements 130.3 vorhandene Ausnehmung 204 und wird dort verrastet. Auf diese Weise wird die Seitenwand 126 der Hutschiene 12 in diesem Bereich klemmend gehalten, so dass eine Lagefixierung des Unterteils 20 und damit des Wandlerbausteins 10 erreicht wird (ZU-Position, siehe Fig. 24).

Um das Oberteil 24 an dem Unterteil 20.3 befestigen zu können, kann der Sicherungsbügel 28.3 von der Seite der Einkerbung 48 her in die beiden Kanäle 44, 46 des Unterteils 20 eingeführt werden. Der Sicherungsbügel 28.2 besitzt zwei Sicherungsstifte 60, 62, die über einen Querbalken 64.3 miteinander verbunden werden. Der Querbalken 64.3 kommt dabei in der Einkerbung 48 zu liegen, so dass der Sicherungsbügel 28.3 vollständig in das Unterteil 20.3 eingeführt werden kann. An dem Querbalken 64.3 des Sicherungsbügels 28.3 ist im vorliegenden Beispielsfall ein Griffelement 206 vorhanden. Mit Hilfe dieses Griffelements 206 kann der Querbalken 64.3 und damit der Sicherungsbügel 28.3 wieder ein Stück weit aus dem Unterteil 20.3 herausgezogen werden.

## Patentansprüche

1. Wandlerbaustein (10, 10.3) zum Anschließen einer Wandlerlasche,
- mit einem Unterteil (20, 20.3), das an einem Montageelement befestigbar ist,
- mit zumindest einem Oberteil (24), das an dem Unterteil (20, 20.3) befestigt ist,
- mit zumindest einer Gewindeplatte (22), die zwischen dem zumindest einen Oberteil (24) und dem Unterteil (20, 20.3) positioniert ist,
- mit zumindest einer Anschlusslasche (26), die an dem zumindest einen Oberteil (24) lagefixierbar ist.

2. Wandlerbaustein nach Anspruch 1,
- **dadurch gekennzeichnet, dass**
- an der Unterseite (30) des Unterteils (20, 20.3) zwei kanalartige Einkerbungen (34, 36) vorhanden sind, die über den Seitenwänden (126) einer Hutschiene (12) positionierbar sind,
- die inneren Wände (122, 124) der beiden kanalartigen Einkerbungen (34, 36) an der Innenseite der Seitenwände (126) der Hutschiene (12) anlegbar sind.

3. Wandlerbaustein nach Anspruch 2,
- **dadurch gekennzeichnet, dass**
- eine der beiden kanalartigen Einkerbungen (36) hakenförmig ausgebildet ist,
- eine der beiden kanalartigen Einkerbungen (34) etwa rechteckig ausgebildet ist,
- die Breite (120) der rechteckigen Einkerbung (34) etwas größer ist als die Breite der Seitenwand (126) der Hutschiene (12) inklusive der oberen Umbiegung (128) der Seitenwand (126).

4. Wandlerbaustein nach Anspruch 3,
- **dadurch gekennzeichnet, dass**
- im Bereich der rechteckigen Einkerbung (34) ein Sicherungselement (130, 130.3) an dem Unterteil (20, 20.3) vorhanden ist,
- das Sicherungselement (130, 130.3) ein Kragelement (136, 136.3) aufweist, das unterhalb der Umbiegung (128) der Seitenwand (126) der Hutschiene (12) positionierbar ist.

5. Wandlerbaustein nach Anspruch 4,
- **dadurch gekennzeichnet, dass**
- das Sicherungselement (130, 130.3) eine Welle (134) aufweist, die in eine Vertiefung (142) des Unterteils (20, 20.3) einlegbar ist,
- das Sicherungselement (130, 130.3) um die Welle (134) verschwenkbar ist, so dass das Kragelement (136, 136.3) des Sicherungselements (130, 130.3) in einer ZU-Position unterhalb der Umbiegung (128) der Seitenwand (126) der Hutschiene (12) positionierbar ist und in einer AUF-Position die Umbiegung (128) der Seitenwand (126) der Hutschiene (12) freigibt.

6. Wandlerbaustein nach Anspruch 5,
- **dadurch gekennzeichnet, dass**
- die Welle (134) des Sicherungselements (130, 130.3) durch das an dem Unterteil (20, 20.3) befestigte Oberteil (24) fixierbar ist.

7. Wandlerbaustein nach einem der Ansprüche 4 bis 6,
- **dadurch gekennzeichnet, dass**
- an dem Sicherungselement (130.3) zumindest eine Ausnehmung (204) vorhanden ist,
- an dem Unterteil (20.3) ein Rasthaken (200) vorhanden ist, der in der ZU-Position des Sicherungselements (130.3) in der Ausnehmung (204) einrastbar ist.

8. Wandlerbaustein nach einem der vorstehenden Ansprüche,
- **dadurch gekennzeichnet, dass**
- zumindest ein Sicherungselement (60, 62, 28, 28.3) vorhanden ist, durch das das zumindest eine Oberteil (24) an dem Unterteil (20, 20.3) fixierbar ist.

9. Wandlerbaustein nach Anspruch 8,
- **dadurch gekennzeichnet, dass**
- an dem zumindest einen Oberteil (24) oder dem Unterteil (20, 20.2) zumindest ein Hakenelement (50) vorhanden ist,
- in dem Unterteil (20, 20.3) beziehungsweise dem zumindest einen Oberteil (24) zumindest eine Vertiefung (42) ausgebildet ist, in die das zumindest eine Hakenelement (50) im befestigten Zustand eintaucht,
- in dem Unterteil (20, 20.3) beziehungsweise dem zumindest einen Oberteil (24) zumindest ein Kanal (44, 46) ausgebildet ist,
- zumindest ein Sicherungsstift (60, 62) als Sicherungselement vorhanden ist,
- der zumindest eine Sicherungsstift (60, 62) in den zumindest einen Kanal (44, 46) einführbar ist, so dass der Sicherungsstift (60, 62) zumindest bereichsweise an der Innenseite des zumindest einen Hakenelements (50) anliegt.

10. Wandlerbaustein nach Anspruch 9,
- **dadurch gekennzeichnet, dass**
- das zumindest eine Hakenelement (50) zumindest bereichsweise eine seitlich offene Nut (54) aufweist,
- der zumindest eine Sicherungsstift (60, 62) in die seitlich offene Nut (54) des zumindest einen Hakenelements (50) eingreift.

11. Wandlerbaustein nach Anspruch 9 oder 10,
- **dadurch gekennzeichnet, dass**
- der zumindest eine Sicherungsstift (60, 62) zumindest einen Rasthebel (70, 71) aufweist, der parallel zur Längsrichtung des Sicherungsstifts (28, 28.3) verläuft,
- die Rastnase (72, 73) des Rasthebels (70, 71) in eine Einkerbung (74, 75) des Unterteils (20, 20.3) beziehungsweise des zumindest einen Oberteils (24) einrastbar ist.

12. Wandlerbaustein nach einem der Ansprüche 9 bis 11,
- **dadurch gekennzeichnet, dass**
- an dem zumindest einen Oberteil (24) oder dem Unterteil (20, 20.3) zumindest zwei Hakenelemente (50) vorhanden sind,
- in dem Unterteil (20, 20.3) beziehungsweise dem zumindest einen Oberteil (24) für jedes Hakenelement (50) eine Vertiefung (42) ausgebildet ist,
- in dem Unterteil (20, 20.3) beziehungsweise dem zumindest einen Oberteil (24) zwei parallel verlaufende Kanäle (44, 46) ausgebildet sind,
- in jeden der beiden Kanäle (44, 46) ein Sicherungsstift (60, 62) einführbar ist.

13. Wandlerbaustein nach Anspruch 12,
- **dadurch gekennzeichnet, dass**
- die beiden Sicherungsstifte (60, 62) durch einen Querbalken (64, 64.3) zu einem U-förmigen Sicherungsbügel (28, 28.3) verbunden sind.

14. Wandlerbaustein nach einem der vorstehenden Ansprüche,
- **dadurch gekennzeichnet, dass**
- in dem zumindest einen Oberteil (24) eine Vertiefung (96) ausgebildet ist, in die die zumindest eine Anschlusslasche (26) eingelegt ist.

15. Wandlerbaustein nach einem der vorstehenden Ansprüche,
- **dadurch gekennzeichnet, dass**
- in dem zumindest einen Oberteil (24) zwei Ausnehmungen (92) vorhanden sind, die durch einen Steg (94) voneinander getrennt sind,
- die zumindest eine Gewindeplatte (22) zwei erhabene Bereiche (80) aufweist, die innerhalb der Ausnehmungen (92) des Oberteils (24) positioniert sind, so dass die erhabenen Bereiche (80) an der Unterseite der Anschlusslasche (26) anliegen.

16. Wandlerbaustein nach Anspruch 15,
- **dadurch gekennzeichnet, dass**
- an der zumindest einen Gewindeplatte (22) mehrere Kragstege (90) vorhanden sind, die unterhalb des zumindest einen Oberteils (24) positioniert sind.

17. Wandlerbaustein nach einem der vorstehenden Ansprüche,
- **dadurch gekennzeichnet, dass**
- die zumindest eine Gewindeplatte (22) seitlich einen hakenförmigen Kragarm (110) aufweist.

18. Wandlerbaustein nach Anspruch 17,
- **dadurch gekennzeichnet, dass**
- an dem hakenförmigen Kragarm (110) ein Anschlusselement, insbesondere eine Rahmenklemme (118) befestigt ist.

19. Elektromechanisches Bauteil (160),
- mit einem gemeinsamen Unterteil (20.2),
- mit mehreren Oberteilen (24), die mit einem gewissen gegenseitigen Abstand zueinander an dem gemeinsamen Unterteil (20.2) befestigt sind,
- mit mehreren Sicherungselementen (28), durch die die Oberteile (24) an dem gemeinsamen Unterteil (20.2) fixierbar sind.

20. Elektromechanisches Bauteil nach Anspruch 19,
- **dadurch gekennzeichnet, dass**
- an dem Oberteil (24) oder dem gemeinsamen Unterteil (20.2) zumindest ein Hakenelement (50) vorhanden ist,
- in dem gemeinsamen Unterteil (20.2) beziehungsweise dem Oberteil (24) zumindest eine Vertiefung (42) ausgebildet ist, in die das zumindest eine Hakenelement (50) im befestigten Zustand eintaucht,
- in dem gemeinsamen Unterteil (20.2) beziehungsweise dem Oberteil (24) zumindest ein Kanal (44, 46) ausgebildet ist,
- zumindest ein Sicherungsstift (60, 62) als Sicherungselement (28) vorhanden ist,
- der zumindest eine Sicherungsstift (60, 62) in den zumindest einen Kanal (44, 46) einführbar ist, so dass der Sicherungsstift (60, 62) zumindest bereichsweise an der Innenseite des zumindest einen Hakenelements (50) anliegt.

21. Elektromechanisches Bauteil nach Anspruch 20,
- **dadurch gekennzeichnet, dass**
- das zumindest eine Hakenelement (50) zumindest bereichsweise eine seitlich offene Nut (54) aufweist,
- der zumindest eine Sicherungsstift (60, 62) in die seitlich offene Nut (54) des zumindest einen Hakenelements (50) eingreift.

22. Elektromechanisches Bauteil nach Anspruch 20 oder 21,
- **dadurch gekennzeichnet, dass**
- der zumindest eine Sicherungsstift (60, 62) zumindest einen Rasthebel (70, 71) aufweist, der parallel zur Längsrichtung des Sicherungsstifts (60, 62) verläuft,
- die Rastnase (72, 73) des Rasthebels (70, 71) in eine Einkerbung (74, 75) des gemeinsamen Unterteils (20.2) beziehungsweise des Oberteils (24) einrastbar ist.

23. Elektromechanisches Bauteil nach einem der Ansprüche 20 bis 22,
- **dadurch gekennzeichnet, dass**
- an dem Oberteil (24) oder dem gemeinsamen Unterteil (20.2) zumindest zwei Hakenelemente (50) vorhanden sind,
- in dem gemeinsamen Unterteil (20.2) beziehungsweise dem Oberteil (24) für jedes Hakenelement (50) eine Vertiefung (42) ausgebildet ist,
- in dem gemeinsamen Unterteil (20.2) beziehungsweise dem Oberteil (24) zwei parallel verlaufende Kanäle (44, 46) ausgebildet sind,
- in jeden der beiden Kanäle (44, 46) ein Sicherungsstift (60, 62) einführbar ist.

24. Elektromechanisches Bauteil nach Anspruch 23,
- **dadurch gekennzeichnet, dass**
- die beiden Sicherungsstifte (60, 62) durch einen Querbalken (64) zu einem U-förmigen Sicherungsbügel (28) verbunden sind.

25. Elektromechanisches Bauteil nach einem der Ansprüche 19 bis 24,
- **dadurch gekennzeichnet, dass**
- zwischen dem gemeinsamen Unterteil (20.2) und jedem Oberteil (24) eine Gewindeplatte (22) vorhanden ist,
- an jedem Oberteil (24) eine Anschlusslasche (24) befestigt ist.

26. Elektromechanisches Bauteil nach einem der Ansprüche 19 bis 25,
- **dadurch gekennzeichnet, dass**
- das gemeinsame Unterteil (20.2) eine Montageplatte (162) aufweist, die an zumindest einem Feldprofil (166) befestigbar ist,
- an der Montageplatte (162) mehrere erhabene Bereiche (168) ausgebildet sind, an denen jeweils ein Oberteil (24) befestigt ist.

27. Elektromechanisches Bauteil nach Anspruch 26,
- **dadurch gekennzeichnet, dass**
- an der Unterseite (172) der Montageplatte (162) zumindest ein Rasthaken (174) vorhanden ist, der mit seiner Rastnase (176) an dem Feldprofil (166) verrastbar ist.

28. Elektromechanisches Bauteil nach Anspruch 27,
- **dadurch gekennzeichnet, dass**
- im Bereich der Rückseite der Rastnase (176) des Rasthakens (174) ein Sperrelement (180) positionierbar ist.
